# FASCICULE DE BREVET EUROPEEN

(11) **EP 2 947 783 B1**
(45) Date de publication et mention de la délivrance du brevet: **12.04.2017**
(21) Numéro de dépôt: 15167900.8
(22) Date de dépôt: 15.05.2015
(51) Int. Cl.: H04B 1/403

(54) **DISPOSITIF ET PROCEDE D'EMISSION ET/OU DE RECEPTION DE SIGNAUX DANS AU MOINS DEUX BANDES DE FREQUENCES DE TRANSMISSION SYMETRIQUES**
VORRICHTUNG UND VERFAHREN ZUM SENDEN UND/ODER EMPFANGEN VON SIGNALEN AUF MINDESTENS ZWEI SYMMETRISCHEN ÜBERTRAGUNGSFREQUENZBÄNDERN
DEVICE AND METHOD FOR TRANSMITTING AND/OR RECEIVING SIGNALS IN AT LEAST TWO SYMMETRICAL TRANSMISSION FREQUENCY BANDS

(30) Priorité: 20.05.2014 FR 1454520
(43) Date de publication de la demande: 25.11.2015
(73) Titulaire: Commissariat à l'Énergie Atomique et aux Énergies Alternatives, 75015 Paris (FR)
(72) Inventeur: GONZALEZ JIMENEZ, José-Luis, 38340 VOREPPE (FR)
(74) Mandataire: Brevalex

(56) Documents cités:
- US-A- 5 852 603
- US-A1- 2011 080 528
- ODED KATZ ET AL: "A fully integrated SiGe E-BAND transceiver chipset for broadband point-to-point communication", RADIO AND WIRELESS SYMPOSIUM (RWS), 2012 IEEE, IEEE, 15 janvier 2012 (2012-01-15), pages 431-434, XP032153370, DOI: 10.1109/RWS.2012.6175323 ISBN: 978-1-4577-1153-4

## Description

### DOMAINE TECHNIQUE ET ART ANTÉRIEUR

L'invention concerne le domaine des dispositifs émetteurs et/ou récepteurs, et notamment celui des dispositifs émetteurs et/ou récepteurs sans fil intégrés faisant appel à des signaux périodiques stables en fréquence pour réaliser une ou plusieurs transpositions de fréquences de signaux dans la partie émission et/ou la partie réception de ces dispositifs, par exemple pour réaliser une émission et une réception de signaux dans au moins deux bandes de fréquences de transmission différentes. L'invention concerne notamment un dispositif et un procédé permettant de générer des signaux périodiques stables en fréquence avec un nombre réduit d'oscillateurs locaux grâce à l'utilisation des propriétés de symétrie des bandes de fréquences utilisées.

L'invention est avantageusement utilisée dans des dispositifs émetteurs et/ou récepteurs de type FDD (« Frequency Division Duplexing ») et/ou à architecture multicanaux, par exemple de type E-Band.

Un dispositif de synthèse de fréquence permet de fournir un signal périodique stable en fréquence destiné à être utilisé par exemple dans un système de communication radiofréquence (RF). Lors d'une émission de signaux, un signal contenant l'information à envoyer est modulé avec le signal périodique stable en fréquence servant de signal porteur pour véhiculer cette information. La synthèse de fréquence réalisée définit dans ce cas la valeur de la fréquence porteuse d'émission. Lors d'une réception de signaux, la synthèse de fréquence permet de fournir ce signal périodique stable en fréquence pour démoduler l'information reçue. Le signal périodique stable en fréquence peut également servir à réaliser une transposition de fréquences entre la bande de base et des fréquences intermédiaires, et/ou entre les fréquences intermédiaires et les fréquences porteuses d'émission et de réception.

Des signaux périodiques stables en fréquence sont généralement générés par des oscillateurs locaux au sein de générateurs de fréquences de type PLL (boucle à verrouillage de phase). Dans certains cas, les dispositifs d'émission - réception requièrent au moins deux signaux stables de fréquences différentes, l'un pour la partie émetteur et l'autre pour la partie récepteur, ces deux signaux devant être fournis simultanément par le générateur de fréquences. De plus, si le dispositif d'émission - réception comporte plusieurs canaux parallèles d'émission - réception, plusieurs signaux périodiques stables en fréquence et de différentes fréquences sont généralement requis simultanément par les différents canaux.

Dans le cas d'un dispositif émetteur - récepteur de type E-Band, deux bandes de fréquences de transmission de largeur égale à 5 GHz et localisées autour de 70 GHz (71 - 76 GHz) et de 80 GHz (81 - 86 GHz) sont utilisées, l'une pour l'émission et l'autre pour la réception de signaux. De plus, un tel dispositif doit pouvoir permuter ces deux bandes de fréquences pour l'émission et la réception. Un tel dispositif est généralement réalisé en faisant appel à un premier étage de conversion de fréquences comportant un mélangeur utilisant un premier signal haute fréquence.

Le document US 5 852 603 décrit un dispositif émetteur - récepteur de type FDD dans lequel deux signaux stables en fréquence sont générés pour un premier étage de conversion par un dispositif de synthèse de fréquence. Dans ce dispositif, les fréquences générées ont des valeurs fixes et ne peuvent pas être permutées entre la partie émission et la partie réception du dispositif.

Le document de O. Katz et al., « A fully integrated SiGe E-BAND transceiver chipset for broadband point-to-point communication », Radio and Wireless Symposium (RWS), 2012 IEEE, pages 431-434, 15-18 janvier 2012, décrit un dispositif émetteur - récepteur de type FDD adapté au standard de communication E-Band. Pour pouvoir réaliser simultanément une émission et une réception de signaux dans les deux bandes de fréquences de transmission différentes et pour pouvoir permuter ces deux bandes, deux générateurs de signaux distincts de type PLL ainsi qu'un dispositif permettant de permuter l'envoi des signaux de sortie de ces deux générateurs dans les parties émission et réception sont utilisés.

Faire appel à plusieurs générateurs de signaux distincts est une solution coûteuse, encombrante et qui consomme beaucoup d'énergie électrique. De plus, dans un tel dispositif, la durée pour réaliser la permutation des bandes de fréquences d'émission et de réception dépend de la durée de verrouillage des PLL, cette durée pouvant être trop importante pour certaines applications.

De plus, les deux bandes de fréquences de transmission sont divisées en plusieurs canaux, ou sous-bandes, comme décrit dans le document « RADIO FREQUENCY CHANNEL ARRANGEMENTS FOR FIXED SERVICE SYSTEMS OPERATING IN THE BANDS 71-76 GHz AND 81-86 GHz », Electronic Communications Commitee (ECC), mai 2013. Ces canaux sont centrés sur différentes fréquences en fonction de la largeur de chaque canal et sont parfois répartis de manière non-uniforme au sein des bandes de fréquences de transmission. Dans ce cas, il est nécessaire de faire appel, pour les transpositions de fréquences, à des signaux périodiques de fréquences différentes qui ne sont pas régulièrement espacées les unes des autres.

Par exemple, chacune des bandes de fréquences de transmission 71 - 76 GHz et 81 - 86 GHz peut être régulièrement divisée en 19 canaux de 250 MHz de large, en conservant des bandes de garde de 125 MHz aux extrémités des bandes de fréquences de transmission. Les canaux ont dans ce cas des fréquences centrales consécutives régulièrement espacées les unes des autres. Il est également possible que les canaux soient plus larges, par exemple avec des largeurs comprises entre 500 MHz et 4500 MHz, pour des applications TDD (« Time Division Duplexing ») et FDD cross-band. Pour les applications FDD, l'émetteur fonctionne par exemple dans la bande basse de fréquences de transmission (71 - 76 GHz) et le récepteur dans la bande haute de fréquences de transmission (81 - 86 GHz). Dans la plupart des cas, les canaux utilisés en émission et en réception sont symétriques, c'est-à-dire ont des largeurs similaires dans les bandes haute et basse de fréquences de transmission, et donc les deux bandes de fréquences de transmission sont divisées de la même manière.

Dans l'exemple ci-dessus, lorsque les canaux ont une largeur supérieure à 500 MHz, les fréquences centrales de ces canaux ne sont pas consécutives pour tous les canaux dans les bandes haute et basse de fréquences de transmission, ce qui implique que les rapports numériques entre les valeurs des fréquences centrales des canaux sont différents. La transposition fréquentielle dans ces canaux est dont complexe, notamment lorsque ces différentes fréquences doivent être obtenues simultanément à partir d'une seule fréquence de référence via des multiplicateurs ou des diviseurs entiers ou fractionnaires de fréquence. Le dispositif de synthèse de fréquence utilisé est notamment complexifié dès lors que plusieurs fréquences doivent être générées simultanément et lorsque les rapports entre ces fréquences ne sont pas des valeurs entières faibles.

Par exemple, pour des canaux de largeur égale à 1 GHz, les fréquences centrales de ces canaux dans la bande basse de fréquences de transmission 71 - 76 GHz sont égales à 71,825 GHz, 72,625 GHz, 74,125 GHz et 75,125 GHz. Leur plus grand diviseur commun est 125 MHz mais leur facteurs de multiplication sont 574, 581, 593 et 601, dont les deux derniers entiers sont des nombres premiers.

### EXPOSÉ DE L'INVENTION

Un but de la présente invention est de proposer un nouveau type de dispositif d'émission et/ou de réception de signaux destinés à être transmis dans au moins deux bandes de fréquences de transmission symétriques ne présentant pas les inconvénients des dispositifs de l'art antérieur exposés précédemment, et permettant de générer plusieurs signaux périodiques stables en fréquence sans faire appel à autant d'oscillateurs locaux que de signaux destinés à être générés, notamment lorsque les fréquences centrales de ces signaux ne sont pas consécutives.

Pour cela, la présente invention propose un dispositif d'émission et/ou de réception de signaux destinés à être transmis dans au moins deux bandes de fréquences de transmission symétriques par rapport à une première fréquence de symétrie F_{CA} et telles que chacune des deux bandes de fréquences de transmission comporte au moins deux canaux, ou groupes de canaux, symétriques par rapport à des deuxièmes fréquences de symétrie F_{CLA}, F_{CUA}, comportant au moins :
- des premiers moyens aptes à générer un signal périodique de fréquence F_{A}, un signal périodique de fréquence F_{B} = F_{A}/N1, un signal périodique de fréquence F₁ égale à |F_{CA} - F_{CLA}| et un signal périodique de fréquence F₂ égale à la différence entre une fréquence centrale d'un des canaux ou groupes de canaux et la deuxième fréquence de symétrie associée au dit un des canaux ou groupes de canaux, et dans lequel F_{A} = N1.(F_{CLA} + F₁)/(N1 + 1) avec N1 nombre supérieur à 1 ;
- des deuxième moyens aptes à réaliser une première opération non linéaire entre les signaux périodiques de fréquences F_{A} et F₁ générant un premier signal multi-tonalités dont le spectre fréquentiel comporte deux raies principales aux fréquences F_{A} - F₁ et F_{A} + F₁, et aptes à réaliser une deuxième opération non linéaire entre les signaux périodiques de fréquences F_{B} et F₂ générant un deuxième signal multi-tonalités dont le spectre fréquentiel comporte deux raies principales aux fréquences F_{B} - F₂ et F_{B} + F₂.

Un tel dispositif utilise donc judicieusement les symétries entre les bandes de fréquences de transmission et entre les canaux pour générer des signaux multi-tonalités dont les spectres fréquentiels comporte des raies principales à des fréquences particulières permettant de générer, à partir de ces signaux multi-tonalités, par exemple via des filtrages ou des récupérations de fréquences, des signaux périodiques stables en fréquence adaptés à des transpositions de fréquences destinées à être réalisées par le dispositif d'émission et/ou de réception. Un tel dispositif évite donc de faire appel à plusieurs oscillateurs locaux pour générer ces signaux périodiques stables en fréquence ainsi qu'à des structures de rebouclage et de stabilisation (PLL) spécifiques pour chacun des signaux.

La fréquence F₁ peut également être exprimée comme étant égale à |F_{CA} - F_{CUA}|. De plus, la fréquence F_{A} peut également être exprimée comme étant telle que F_{A} = N1.(F_{CUA} - F₁)/(N1 + 1).

Le premier signal multi-tonalités peut servir à la génération de signaux périodiques stables en fréquence utilisés pour une transposition de fréquences entre les fréquences RF et des fréquences intermédiaires, et le deuxième signal multi-tonalités peut servir à la génération de signaux périodiques stables en fréquence utilisés pour une transposition de fréquences entre les fréquences intermédiaires et des basses fréquences telles que la bande de base. Les signaux périodiques générés sont tous synchronisés en phase du fait qu'ils sont générés à partir d'un même signal.

Dans les signaux multi-tonalités, les raies principales sont celles présentant les plus grandes amplitudes parmi l'ensemble des raies spectrales au sein du spectre fréquentiel de chaque signal.

Le dispositif selon l'invention peut correspondre à un dispositif de communication point à point de type E-band multicanaux ou monocanal.

Le dispositif selon l'invention peut correspondre à un système de type FDD faisant appel à plusieurs signaux périodiques de fréquences différentes et permettant de permuter les bandes de fréquences d'émission et de réception, particulièrement dans le cas de multiple canaux de fréquences centrales distribuées non-uniformément dans les bandes de fréquences d'émission et de réception mais présentant une symétrie entre eux.

L'invention concerne par exemple un dispositif de transmission RF ou électro-optique de signaux.

N1 est avantageusement un nombre entier supérieur à 1, notamment lorsque les signaux périodiques de fréquences F_{A} et F_{B} sont générés depuis une même PLL en utilisant un ou plusieurs diviseurs de fréquence appliquant un rapport de division entier.

Les deuxièmes moyens peuvent comporter au moins un premier mélangeur apte à réaliser la première opération non linéaire et un deuxième mélangeur apte à réaliser la deuxième opération non linéaire.

Les premiers moyens peuvent comporter une première boucle à verrouillage de phase apte à délivrer en sortie les signaux périodiques de fréquences F_{A} et F_{B} et une deuxième boucle à verrouillage de phase apte à délivrer en sortie les signaux périodiques de fréquences F₁ et F₂, ou, lorsque la fréquence F_{A} correspond à un multiple entier de chacune des fréquences F_{B}, F₁ et F₂, les premiers moyens comportent une seule boucle à verrouillage de phase apte à délivrer en sortie les signaux périodiques de fréquences F_{A}, F_{B}, F₁ et F₂.

Un tel dispositif peut avantageusement comporter un nombre de PLL inférieur au nombre de canaux utilisés, voir une seule PLL.

Le dispositif peut comporter en outre au moins :
- des premier et deuxième circuits récupérateurs de fréquence recevant en entrée le premier signal multi-tonalités et délivrant chacun en sortie un signal périodique respectivement de fréquence F_{A}-F₁ et F_{A}+F₁ ;
- des troisième et quatrième circuits récupérateurs de fréquence recevant en entrée le deuxième signal multi-tonalités et délivrant chacun en sortie un signal périodique respectivement de fréquence F_{B}-F₂ et F_{B}+F₂.

Dans ce cas, le dispositif peut comporter en outre, lorsque chacune des deux bandes de fréquences de transmission comporte au moins deux groupes d'au moins deux canaux, des troisièmes moyens aptes à réaliser une troisième opération non linéaire entre le signal périodique de fréquence F_{B}-F₂ et un signal périodique de fréquence F₃ générant un troisième signal multi-tonalités dont le spectre fréquentiel comporte deux raies principales aux fréquences F_{B}-F₂-F₃ et F_{B}-F₂+F₃, et aptes à réaliser une quatrième opération non linéaire entre les signaux périodiques de fréquences F_{B}+F₂ et F₃ générant un quatrième signal multi-tonalités dont le spectre fréquentiel comporte deux raies principales aux fréquences F_{B}+F₂-F₃ et F_{B}+F₂+F₃.

Dans ce cas, le dispositif peut comporter en outre au moins :
- des cinquième et sixième circuits récupérateurs de fréquence recevant en entrée le troisième signal multi-tonalités et délivrant chacun en sortie un signal périodique respectivement de fréquence F_{B}-F₂-F₃ et F_{B}-F₂+F₃ ;
- des septième et huitième circuits récupérateurs de fréquence recevant en entrée le quatrième signal multi-tonalités et délivrant chacun en sortie un signal périodique de fréquence F_{B}+F₂-F₃ et F_{B}+F₂+F₃.

Chaque circuit récupérateur de fréquence peut comporter au moins un oscillateur verrouillé par injection (ILO) et/ou un filtre passe-bande. Il peut être avantageux de faire appel à un ou plusieurs ILO lorsque, pour des hautes fréquences telles que celles utilisées dans un dispositif de type E-Band, la fréquence du signal périodique destiné à être délivré correspond à une raie du spectre fréquentiel du signal multi-tonalités qui est proche d'une ou plusieurs autres raies de ce spectre fréquentiel. Le ou les ILO utilisés ont alors une fréquence de résonance proche de ladite fréquence à récupérer afin qu'il(s) se verrouille(nt) sur celle-ci et rejette(nt) la fréquence de la ou des autres raies du spectre fréquentiel. La valeur de la fréquence sur laquelle un ILO se verrouille est notamment fonction d'une valeur d'une tension de commande destinée à être appliquée en entrée de l'ILO. Lorsque des filtres passe-bande sont utilisés, ces filtres ont avantageusement une fréquence centrale de filtrage centrée sur la fréquence destinée à être récupérée.

En variante, le dispositif peut comporter en outre :
- des premier et deuxième circuits récupérateurs de fréquence recevant en entrée le premier signal multi-tonalités et délivrant chacun en sortie un signal périodique respectivement de fréquence F_{A}-F₁ et F_{A}+F₁ ;
- des quatrièmes moyens aptes à réaliser une troisième opération non linéaire entre le deuxième signal multi-tonalités et un signal périodique de fréquence F₃ générant un cinquième signal multi-tonalités dont le spectre comporte quatre raies principales aux fréquences F_{B}-F₂-F₃, F_{B}-F₂+F₃, F_{B}+F₂-F₃ et F_{B}+F₂+F₃ ;
- au moins un oscillateur verrouillé par injection commutable recevant en entrée le cinquième signal multi-tonalités et délivrant en sortie au moins un signal périodique de fréquence égale à l'une des fréquences F_{B}-F₂-F₃, F_{B}-F₂+F₃, F_{B}+F₂-F₃ et F_{B}+F₂+F₃.

Le dispositif peut comporter en outre :
- un étage de conversion entre les bandes de fréquences de transmission et une bande de fréquences intermédiaires, comprenant au moins un troisième mélangeur apte à recevoir en entrée un signal reçu par le dispositif dans l'une des deux bandes de fréquences de transmission et l'un des deux signaux périodiques de fréquences F_{A}-F₁ et F_{A}+F₁ et au moins un quatrième mélangeur apte à recevoir en entrée un signal en bande de fréquences intermédiaires destiné à être émis par le dispositif dans l'autre des deux bandes de fréquences de transmission et l'autre des deux signaux périodiques de fréquences F_{A}-F₁ et F_{A}+F₁ ;
- un étage de conversion entre la bande de fréquences intermédiaires et une bande de base, comprenant une pluralité de cinquièmes mélangeurs aptes à recevoir chacun en entrée un signal de sortie du troisième mélangeur et l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃, et une pluralité de sixièmes mélangeurs aptes à recevoir chacun en entrée un signal en bande de base destiné à être émis par le dispositif dans ladite autre des deux bandes de fréquences de transmission et l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃.

L'invention concerne également un procédé d'émission et/ou de réception de signaux dans au moins deux bandes de fréquences de transmission symétriques par rapport à une première fréquence de symétrie F_{CA} et telles que chacune des deux bandes de fréquences de transmission comporte au moins deux canaux, ou groupes de canaux, symétriques par rapport à des deuxièmes fréquences de symétrie F_{CLA}, F_{CUA}, comportant au moins les étapes de :
- génération d'un signal périodique de fréquence F_{A}, d'un signal périodique de fréquence F_{B} = F_{A}/N1, d'un signal périodique de fréquence F₁ égale à |F_{CA} - F_{CLA}| et d'un signal périodique de fréquence F₂ égale à la différence entre une fréquence centrale d'un des canaux ou groupe de canaux et la deuxième fréquence de symétrie associée au dit un des canaux ou groupe de canaux, et dans lequel F_{A} = N1.(F_{CLA} + F₁)/(N1 + 1) avec N1 nombre supérieur à 1 ;
- réalisation d'une première opération non linéaire entre les signaux périodiques de fréquences F_{A} et F₁ générant un premier signal multi-tonalités dont le spectre fréquentiel comporte deux raies principales aux fréquences F_{A}-F₁ et F_{A}+F₁, et d'une deuxième opération non linéaire entre les signaux périodiques de fréquence F_{B} et F₂ générant un deuxième signal multi-tonalités dont le spectre fréquentiel comporte deux raies principales aux fréquences F_{B}-F₂ et F_{B}+F₂.

Le procédé peut comporter en outre les étapes de :
- génération de signaux périodiques de fréquences F_{A}-F₁ et F_{A}+F₁ à partir du premier signal multi-tonalités ;
- génération de signaux périodiques de fréquences F_{B}-F₂ et F_{B}+F₂ à partir du deuxième signal multi-tonalités.

Dans ce cas, le procédé peut comporter en outre, lorsque chacune des deux bandes de fréquences de transmission comporte au moins deux groupes d'au moins deux canaux, la réalisation d'une troisième opération non linéaire entre le signal périodique de fréquence F_{B}-F₂ et un signal périodique de fréquence F₃ générant un troisième signal multi-tonalités dont le spectre fréquentiel comporte deux raies principales aux fréquences F_{B}-F₂-F₃ et F_{B}-F₂+F₃, et d'une quatrième opération non linéaire entre les signaux périodiques de fréquences F_{B}+F₂ et F₃ générant un quatrième signal multi-tonalités dont le spectre comporte deux raies principales aux fréquences F_{B}+F₂-F₃ et F_{B}+F₂+F₃.

Dans ce cas, le procédé peut comporter en outre les étapes de :
- génération de signaux périodiques de fréquences F_{B}-F₂-F₃ et F_{B}-F₂+F₃ à partir du troisième signal multi-tonalités ;
- génération de signaux périodiques de fréquences F_{B}+F₂-F₃ et F_{B}+F₂+F₃ à partir du quatrième signal multi-tonalités.

En variante, le procédé peut comporter en outre les étapes de :
- génération de signaux périodiques de fréquences F_{A}-F₁ et F_{A}+F₁ à partir du premier signal multi-tonalités ;
- réalisation d'une troisième opération non linéaire entre le deuxième signal multi-tonalités et un signal périodique de fréquence F₃ générant un cinquième signal multi-tonalités dont le spectre comporte quatre raies principales aux fréquences F_{B}-F₂-F₃, F_{B}-F₂+F₃, F_{B}+F₂-F₃ et F_{B}+F₂+F₃ ;
- génération d'au moins un signal périodique de fréquence égale à l'une des fréquences F_{B}-F₂-F₃, F_{B}-F₂+F₃, F_{B}+F₂-F₃ et F_{B}+F₂+F₃ à partir du cinquième signal multi-tonalités.

Le procédé peut comporter en outre :
- lors d'une réception d'un signal dans l'une des deux bandes de fréquences de transmission, une première transposition dans une bande de fréquences intermédiaires du signal reçu en utilisant l'un des deux signaux périodiques de fréquences F_{A}-F₁ et F_{A}+F_{1,} puis une deuxième transposition en bande de base du signal issu de la première transposition en utilisant l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃, et
- lors d'une émission d'un signal dans l'autre des deux bandes de fréquences de transmission, une première transposition dans la bande de fréquences intermédiaires d'un signal en bande de base en utilisant l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃, puis une deuxième transposition dans l'autre des deux bandes de fréquences de transmission du signal issu de la première transposition en utilisant l'autre des deux signaux périodiques de fréquences F_{A}-F₁ et F_{A}+F₁.

Les différents signaux périodiques peuvent correspondre avantageusement à des signaux sinusoïdaux dont les spectres fréquentiels comportent chacun une raie, ou pic, de fréquence égale à la fréquence du signal.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente schématiquement une partie d'un dispositif d'émission et de réception de signaux, objet de la présente invention, selon un mode de réalisation particulier;
- la figure 2 représente des exemples de répartition de canaux dans une bande de fréquences de transmission utilisée dans le dispositif objet de la présente invention ;
- la figure 3 illustre l'utilisation des symétries pour générer les fréquences utilisées dans le dispositif objet de la présente invention ;
- la figure 4 représente un exemple de réalisation d'un dispositif de synthèse de fréquences faisant partie d'un dispositif d'émission et/ou de réception, objet de la présente invention ;
- les figures 5 et 6 représentent des variantes de réalisation de PLL d'un dispositif de synthèse de fréquences faisant partie d'un dispositif d'émission et/ou de réception, objet de la présente invention ;
- la figure 7 représente une partie d'un dispositif de synthèse de fréquences faisant partie d'un dispositif d'émission et/ou de réception, objet de la présente invention, permettant une transmission de données sur quatre canaux dans chacune des bandes de fréquences de transmission ;
- les figures 8A et 8B représentent des variantes de réalisation de PLL d'un dispositif de synthèse de fréquences faisant partie d'un dispositif d'émission et/ou de réception, objet de la présente invention ;
- la figure 9 représente une variante de réalisation d'une PLL d'un dispositif de synthèse de fréquences faisant partie d'un dispositif d'émission et/ou de réception, objet de la présente invention ;
- la figure 10 représente une partie d'un dispositif de synthèse de fréquences faisant partie d'un dispositif d'émission et/ou de réception, objet de la présente invention, permettant une transmission de données sur quatre canaux de fréquences variables dans chacune des bandes de fréquences de transmission ;
- la figure 11 représente une partie d'un dispositif de synthèse de fréquences faisant partie d'un dispositif d'émission et/ou de réception, objet de la présente invention, permettant une transmission de données sur un canal de fréquence variable dans chacune des bandes de fréquences de transmission ;
- la figure 12 représente schématiquement les parties d'un oscillateur verrouillé par injection commutable utilisé dans un dispositif d'émission et/ou de réception, objet de la présente invention ;
- la figure 13 représente schématiquement un exemple de réalisation d'un oscillateur verrouillé par injection commutable utilisé dans un dispositif d'émission et/ou de réception, objet de la présente invention ;
- la figure 14 représente schématiquement un exemple de réalisation d'un circuit récupérateur de fréquence permettant de délivrer en sortie des signaux I/Q de même fréquence et utilisé dans un dispositif d'émission et/ou réception, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

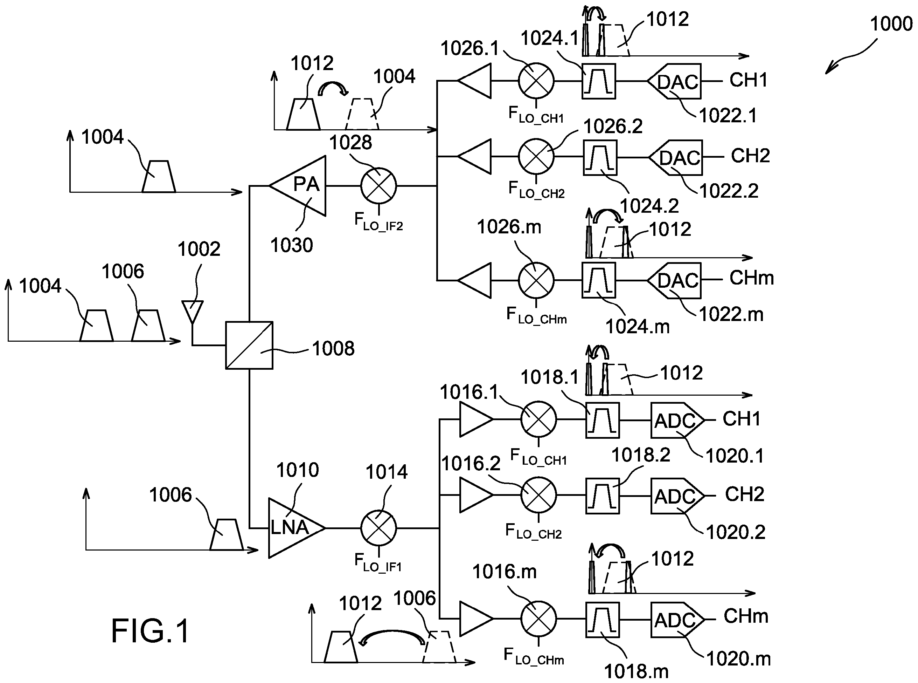

On se réfère tout d'abord à la figure 1 qui représente schématiquement une partie d'un dispositif 1000 d'émission et de réception apte à réaliser une émission et une réception de signaux dans deux bandes de fréquences de transmission RF, par exemple de type E-band (transmission dans les bandes 71 - 76 GHz et 81 - 86 GHz), et réalisant des transpositions de fréquences en utilisant m canaux permettant une division de chacune de ces bandes RF en m sous-bandes fréquentielles, m étant un nombre entier supérieur à 1.

Le dispositif 1000 comporte une antenne 1002 servant à l'émission et à la réception des données. Dans l'exemple décrit ici, les fréquences de la bande de fréquences de transmission utilisée pour l'émission de données, représentée symboliquement avec la référence 1004, sont inférieures à celles de la bande de fréquences de transmission utilisée pour la réception de données, représentée symboliquement avec la référence 1006. La bande basse de fréquences 1004 utilisée pour l'émission de données correspond par exemple à la bande 71 - 76 GHz, et la bande haute de fréquences 1006 utilisée pour la réception de données correspond par exemple à la bande 81 - 86 GHz. En variante, la bande basse de fréquences 1004 pourrait être utilisée pour la réception de données et la bande haute de fréquences 1006 pour l'émission de données. Le dispositif 1000 comporte également un élément 1008 permettant à l'antenne 1002 de fonctionner conjointement avec les éléments d'émission et les éléments de réception du dispositif 1000.

Lorsqu'un signal est reçu par l'antenne 1002, celui-ci est envoyé, via l'élément 1008, en entrée d'un amplificateur faible bruit (LNA) 1010, puis transposé dans une bande de fréquences intermédiaires 1012 par un mélangeur 1014 recevant en entrée le signal reçu et un signal périodique stable de fréquence F_{LO_IF1}, appelé S_{LO_IF1}.

La largeur de la bande haute de fréquences 1006 correspond à celle de la bande de fréquences intermédiaires 1012. Plusieurs convertisseurs analogique - numérique sont utilisés pour convertir les signaux se trouvant dans les différents canaux de cette bande de fréquences. Cette large bande de fréquences 1012 est démultiplexée en fréquence afin d'obtenir m sous-bandes de fréquences moins larges réparties sur m canaux comprenant chacun un convertisseur analogique - numérique, permettant de retrouver les signaux transmis dans les différents canaux de la bande 1006.

Ce démultiplexage est réalisé sur les m canaux via une seconde transposition de fréquences de m parties de la bande de fréquences intermédiaires 1012 vers m bandes de fréquences intermédiaires plus basses, ou directement en bande de base (directement en bande de base sur l'exemple représenté sur la figure 1). Sur la figure 1, ce démultiplexage, ou seconde transposition de fréquences, est réalisé via m mélangeurs 1016.1 - 1016.m recevant chacun en entrée le signal dans la bande de fréquences intermédiaires 1012 et un signal périodique stable de fréquence centrale adaptée à la partie de la bande de fréquences intermédiaires 1012 destinée à être récupérée et transposée en bande de base. Chacun des mélangeurs 1016.1 - 1016.m reçoit donc en entrée, en plus du signal de fréquences intermédiaires, un signal périodique stable de fréquence différente pour chaque canal, ici de fréquences F_{LO_CH1} à F_{LO}__{CHm}, ces signaux étant appelés S_{LO_CH1} à S_{LO_CHm}. Les signaux en bande de base obtenus en sortie des mélangeurs 1016.1 - 1016.m sont ensuite filtrés individuellement par des filtres passe-bande 1018.1 - 1018.m, puis convertis numériquement par des convertisseurs analogiques - numériques 1020.1 - 1020.m, et délivrés sur les canaux CH1 à CHm.

Pour réaliser une émission de signaux, les opérations inverses à celles réalisées lors de la réception précédemment décrite sont mises en oeuvre. Ainsi, les signaux en bande de base des canaux CH1 à CHm sont tout d'abord convertis individuellement par des convertisseurs numériques - analogiques 1022.1 - 1022.m, puis filtrés individuellement par des filtres passe-bande 1024.1 - 1024.m, et transposés dans la bande de fréquences intermédiaires 1012 via un multiplexage dans le domaine fréquentiel réalisé par des mélangeurs 1026.1 - 1026.m recevant chacun en entrée un des signaux analogiques filtrés et un des signaux S_{LO_CH1} à S_{LO}__{CHm}. Les signaux se trouvant dans la bande de fréquences intermédiaires 1012 ainsi combinés forment un seul signal réparti sur la bande de fréquences intermédiaires 1012. Une transposition dans la bande de fréquences 1004 est ensuite réalisée par un mélangeur 1028 recevant en entrée le signal dans la bande de fréquences intermédiaires 1012 ainsi qu'un signal de fréquence F_{LO}__{IF2}, appelé S_{LO}__{IF2}. Le signal de sortie du mélangeur 1028 est enfin amplifié par un amplificateur de puissance 1030 puis émis par l'antenne 1002.

Les différents canaux CH1 à CHm fonctionnent simultanément ou non lors d'une émission ou d'une réception de données.

Dans un dispositif d'émission - réception de type FDD, les bandes de fréquences intermédiaires utilisées à l'émission et à la réception sont similaires.

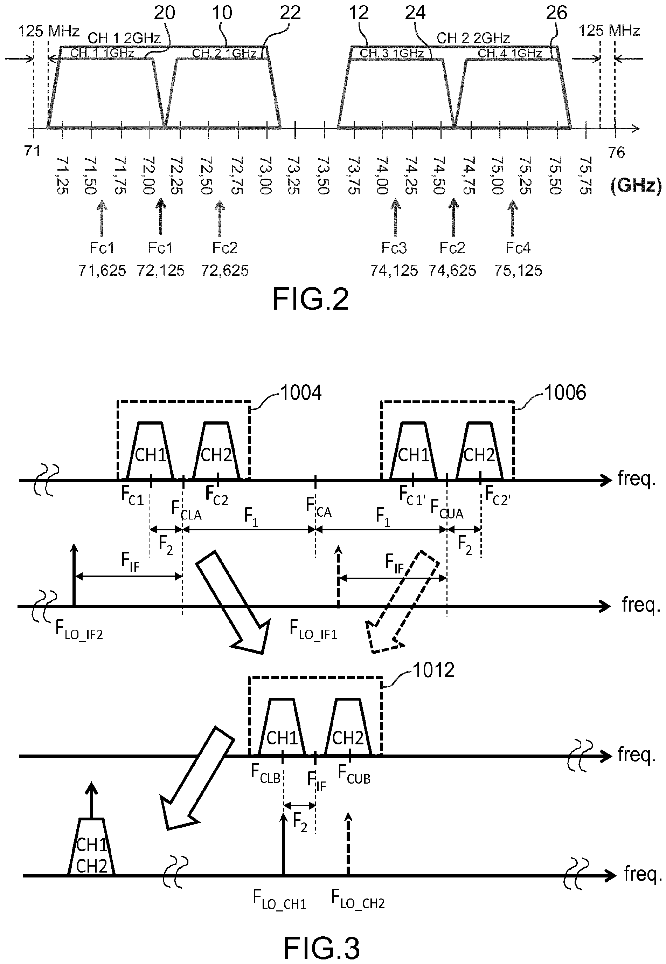

La figure 2 représente deux exemples de répartition des canaux dans la bande basse de fréquences de transmission 71 - 76 GHz.

On voit sur cette figure un premier exemple dans lequel deux canaux CH1 et CH2 référencés 10 et 12, chacun de largeur égale à 2 GHz, sont utilisés dans la bande 71 - 76 GHz. Par analogie avec la figure 1, ce premier exemple correspond à une configuration du dispositif 1000 dans laquelle m = 2. Dans ce cas, le premier canal 10 a une fréquence centrale F_{c1} = 72,125 GHz, et le deuxième canal 12 a une fréquence centrale F_{c2} = 74,625 GHz. Un deuxième exemple est également représenté dans lequel quatre canaux CH1 à CH4 référencés 20, 22, 24 et 26, chacun de largeur égale à 1 GHz, sont utilisés (cas de la figure 1 dans lequel m = 4). Dans ce cas, le premier canal 20 a une fréquence centrale F_{c1} = 71,625 GHz, le deuxième canal 22 a une fréquence centrale F_{c2} = 72,625 GHz, le troisième canal 24 a une fréquence centrale F_{c3} = 74,125 GHz, et le quatrième canal 26 a une fréquence centrale F_{c4} = 75,125 GHz. On voit également sur cette figure que dans tous les cas, des bandes de garde de 125 MHz sont présentes aux extrémités de la bande basse de fréquences de transmission. Une configuration similaire des canaux se retrouve dans la bande haute de fréquences de transmission 81 - 86 GHz.

La génération des signaux S_{LO_CH1} à S_{LO_CHm} et des signaux S_{LO}__{IF1} et S_{LO}__{IF2} est réalisée en utilisant les symétries qui existent entre les fréquences centrales des différents canaux et entre les bandes de fréquences de transmission 1004 et 1006. Ainsi, dans les deux exemples représentés sur la figure 2, on voit que la répartition des canaux dans la bande 71 - 76 GHz est symétrique autour de la fréquence 73,375 GHz, appelée F_{CLA} (idem dans la bande 81 - 86 GHZ autour de la fréquence 83,375 GHz, appelée F_{CUA}). De plus, les deux bandes haute et basse de fréquences de transmission ont chacune une fréquence centrale (73,5 GHz pour la bande 71 - 76 GHz et 83,5 GHz pour la bande 81 - 86 GHz) éloignée de manière égale d'une fréquence de symétrie appelée F_{CA}, qui est égale à 78,5 GHz pour les bandes 71 - 76 GHz et 81- 86 GHz.

La figure 3 illustre le principe utilisé pour générer les signaux S_{LO_CH1} à S_{LO}__{CHm} et des signaux S_{LO}__{IF1} et S_{LO}__{IF2} en fonction des répartitions des canaux dans les bandes de fréquences hautes et basses d'émission - réception.

Dans l'exemple de la figure 3, deux canaux CH1 et CH2 de largeur égale à 2GHz sont présents dans la bande basse de fréquences de transmission 1004 (par exemple la bande 71 - 76 GHz) et sont disposés symétriquement dans cette bande de part et d'autre de la fréquence F_{CLA}. Cette configuration correspond aux canaux 10 et 12 précédemment décrits en liaison avec la figure 2. La distance entre chacune des fréquences centrales F_{c1} et F_{c2} des canaux CH1 et CH2 et la fréquence F_{CLA} est appelée F₂. De même, deux canaux CH1 et CH2 de même largeur sont présents dans la bande haute de fréquences de transmission 1006 (par exemple la bande 81 - 86 GHz) et sont disposés symétriquement dans cette bande de part et d'autre de la fréquence F_{CUA}. La distance entre les fréquences centrales F_{c1'} et F_{c2'} de ces canaux et la fréquence F_{CUA} correspond également à F₂. Les deux fréquences F_{CLA} et F_{CUA} sont à distance égale de la fréquence de symétrie des bandes appelée F_{CA}, cette distance étant appelée F₁.

La fréquence F_{LO_IF2} correspond à la fréquence permettant de réaliser la transposition entre la bande de fréquences intermédiaires 1012 et la bande basse de fréquences de transmission 1004. La fréquence F_{LO_IF1} correspond à la fréquence permettant de réaliser la transposition de la bande haute de fréquences de transmission 1006 dans la bande de fréquences intermédiaires 1012. La distance entre la fréquence F_{LO_IF2} et la fréquence F_{CLA}, appelée F_{IF}, est égale à celle entre la fréquence F_{LO}__{IF1} et la fréquence F_{CUA}.

Les canaux qui sont transposés dans la bande de fréquences intermédiaires 1012 présentent une symétrie autour de la fréquence F_{IF}. Sur l'exemple de la figure 3, les canaux CH1 issus des bandes haute et basse de fréquences de transmission 1004 et 1006 ont tous les deux, après transposition dans la bande de fréquences intermédiaires 1012, une même fréquence centrale F_{CLB} et les canaux CH2 ont tous les deux une même fréquence centrale F_{CUB}. La distance entre F_{IF} et l'une de ces deux fréquences centrales est la même que la distance F₂ identifiée précédemment.

Le passage entre la bande de fréquences intermédiaires 1012 et la bande de base pour les canaux est réalisé à partir des fréquences F_{LO_CH1} et F_{LO_CH2}. Ces deux fréquences sont symétriques par rapport à la fréquence F_{IF}.

Des symétries analogues sont présentes en considérant que chacun des canaux CH1 et CH2 décrits en liaison avec la figure 3 correspond à un groupe d'au moins deux canaux.

Le dispositif 1000 comporte donc un dispositif de synthèse de fréquences permettant de générer simultanément les signaux périodiques stables en fréquence S_{LO_IF1}, S_{LO_IF2}, et S_{LO_CH1} à S_{LO_CHm} dans l'exemple précédemment décrit, et cela avec un minimum d'éléments grâce aux symétries identifiées. Ce dispositif de synthèse de fréquences génère ces signaux en combinant deux composantes fréquentielles, l'une permettant d'obtenir le centre de symétrie et l'autre correspondant à l'espacement entre ce centre et les fréquences désirées. Pour cela, le dispositif de synthèse de fréquences comporte deux parties, basées chacune sur une PLL, l'une permettant de générer les signaux de fréquences F_{LO_IF1} et F_{LO_IF2}, et l'autre permettant de générer les signaux de fréquences F_{LO_CH1} à F_{LO_CHm}.

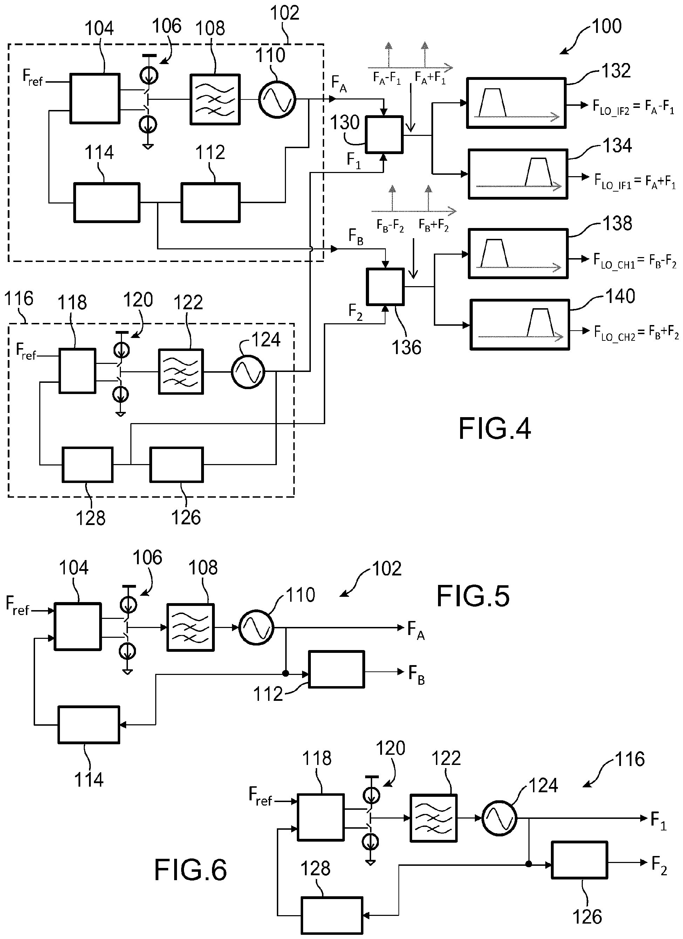

La figure 4 représente un tel dispositif de synthèse de fréquences 100 selon un premier mode de réalisation.

Le dispositif 100 comporte une première PLL 102. Un signal périodique de référence très stable en fréquence, par exemple issu d'un résonateur à quartz, de fréquence F_{ref}, est appliqué sur une première entrée d'un comparateur de phases 104 (PFD pour «Phase Frequency Detector »). Les signaux de sortie du comparateur de phases 104 sont envoyés en entrée d'un circuit de pompe de charge 106 puis d'un filtre passe-haut 108. Le filtre 108 délivre en sortie un signal appliqué sur l'entrée d'un oscillateur 110, ici un VCO (oscillateur commandé en tension), par exemple réalisé sous la forme de paires croisées différentielles (résonateur couplé avec une résistance négative) délivrant en sortie un signal sinusoïdal de fréquence F_{A}. Ce signal de fréquence F_{A} est utilisé pour la génération des signaux de fréquence F_{LO_IF1} et F_{LO_IF2·} Ce signal est appliqué en entrée d'un premier diviseur de fréquence 112 réalisant une division de fréquence de facteur N1 correspondant à un nombre supérieur à 1, et avantageusement un nombre entier supérieur à 1. Ce premier diviseur de fréquence 112 délivre en sortie un signal de fréquence F_{B} = F_{A}/N1 utilisé pour la génération des signaux de fréquence F_{LO_CH1} à F_{LO_CHm} (F_{LO_CH1} et F_{LO_CH2} sur l'exemple de la figure 4). Ce signal est en outre appliqué en entrée d'un deuxième diviseur de fréquence 114 réalisant une division de fréquence de facteur N2 qui correspond à un nombre supérieur à 1, et avantageusement un nombre entier supérieur à 1, et dont la sortie est reliée sur une deuxième entrée du comparateur de phases 104. Le facteur N2 est tel que F_{ref} = F_{B}/N2 = F_{A}/(N1.N2).

Le dispositif 100 comporte une deuxième PLL 116. Le signal de référence de fréquence F_{ref} est appliqué sur une première entrée d'un deuxième comparateur de phases 118. Les signaux de sortie du deuxième comparateur de phases 118 sont envoyés en entrée d'un deuxième circuit de pompe de charge 120 et d'un deuxième filtre passe-haut 122. Le deuxième filtre 122 délivre en sortie un signal appliqué sur l'entrée d'un deuxième oscillateur 124, ici un VCO, délivrant en sortie un signal de fréquence Fi. Ce signal de fréquence F₁ est utilisé pour la génération des signaux de fréquence F_{LO_IF1} et F_{LO_IF2}. Ce signal est appliqué en entrée d'un troisième diviseur de fréquence 126 réalisant une division de fréquence de facteur N3 qui correspond à un nombre supérieur à 1, et avantageusement un nombre entier supérieur à 1. Ce troisième diviseur de fréquence 126 délivre en sortie un signal de fréquence F₂ = F₁/N3 utilisé pour la génération des signaux de fréquence F_{LO_CH1} et F_{LO_CH2}. Ce signal est en outre appliqué en entrée d'un quatrième diviseur de fréquence 128 réalisant une division de fréquence de facteur N4 qui correspond à un nombre supérieur à 1, et avantageusement un nombre entier supérieur à 1, et dont la sortie est reliée sur une deuxième entrée du deuxième comparateur de phases 118. Le facteur N4 est tel que F_{ref} = F₂/N4 = F₁/(N3.N4).

Les oscillateurs 110 et 124 peuvent être réalisés comme décrit dans les documents « A 60 GHz UWB impulse radio transmitter with integrated antenna in CMOS65nm SOI technology » de A. Siligaris et al., Silicon Monolithic Integrated Circuits in RF Systems (SiRF), 2011 IEEE 11th Topical Meeting on, pp. 153-156, 17-19 Jan. 2011 et « A 17.5-to-20.94GHz and 35-to-41.88GHz PLL in 65nm CMOS for wireless HD applications » de O. Richard et al., Solid-State Circuits Conférence Digest of Technical Papers (ISSCC), 2010 IEEE International, pp.252-253, 7-11 Feb. 2010.

Les diviseurs de fréquence 112, 114, 126 et 128 peuvent utiliser différentes architectures selon la valeur de la fréquence divisée. Aux fréquences élevées, les diviseurs de fréquence tels que les diviseurs 112 et 114 utilisent des circuits de type CML (« Current Mode Logic ») ou ILFD (« Injection Locked Frequency Divider »). Les diviseurs de fréquence fonctionnant à plus basses fréquences, par exemple proches de 1 GHz, tels que les diviseurs 126 et 128 utilisent des architectures purement numériques de type compteur. Si les diviseurs 126 et 128 fonctionnent à des fréquences plus élevées, ces diviseurs comportent par exemple un premier étage de division de type CML qui réduit la fréquence à diviser, délivrant par exemple en sortie un fréquence de l'ordre d'1 GHz, puis un second étage formant des diviseurs purement numériques. Les circuits formant les diviseurs de fréquence peuvent être programmables afin que les valeurs des facteurs de division soient ajustables, selon les valeurs des fréquences F_{A}, F_{B}, F₁ et F₂ recherchées.

Les signaux de fréquences F_{A} et F₁ sont appliqués en entrée d'un premier élément 130 réalisant une opération non linéaire entre ces signaux et générant un premier signal multi-tonalités, ou multifréquences, à partir de ces signaux. Ce premier élément 130 correspond par exemple à un mélangeur réalisant une multiplication des signaux d'entrée de fréquences F_{A} et F₁. Le premier signal multi-tonalités obtenu en sortie du premier élément 130 comporte donc, dans son spectre fréquentiel, une première raie principale à la fréquence F_{A}-F₁ qui correspond à la fréquence F_{LO_IF2}, et une deuxième raie principale à la fréquence F_{A}+F₁ qui correspond à la fréquence F_{LO_IF1}. Ce premier signal multi-tonalités est envoyé à l'entrée d'un premier circuit récupérateur de fréquence 132 rejetant les fréquences autres que la fréquence F_{LO_IF2} et délivrant en sortie le signal périodique de fréquence F_{LO_IF2}, et à l'entrée d'un deuxième circuit de récupération de fréquence 134 rejetant les fréquences autres que la fréquence F_{LO_IF1} et délivrant en sortie le signal périodique de fréquence F_{LO_IF1}.

Les signaux de fréquences F_{B} et F₂ sont appliqués en entrée d'un deuxième élément 136 réalisant une opération non linéaire entre ces signaux et générant un deuxième signal multi-tonalités à partir de ces signaux. Ce deuxième élément 136 correspond par exemple à un mélangeur réalisant une multiplication des signaux d'entrée de fréquences F_{B} et F₂. Le deuxième signal multi-tonalités obtenu en sortie du deuxième élément 136 comporte donc, dans son spectre fréquentiel, une première raie principale à la fréquence F_{B}-F₂ qui correspond à la fréquence F_{LO_CH1}, et une deuxième raie principale à la fréquence F_{B}+F₂ qui correspond à la fréquence F_{LO_CH2}. Ce deuxième signal multi-tonalités est envoyé à l'entrée d'un troisième circuit récupérateur de fréquence 138 rejetant les fréquences autres que la fréquence F_{LO_CH1} et délivrant en sortie le signal de fréquence F_{LO_CH1}, et à l'entrée d'un quatrième circuit récupérateur de fréquence 140 rejetant les fréquences autres que la fréquence F_{LO_CH2} et délivrant en sortie le signal de fréquence F_{LO_CH2}.

Les circuits récupérateurs de fréquence 132, 134, 138 et 140 correspondent par exemple à des filtres passe-bande sélectifs tels que des filtres multi-composants ou des filtres comportant des éléments de type MEMS ou BAW (à ondes acoustiques de volume), et/ou des ILO aptes à se verrouiller à la fréquence souhaitée et à délivrer en sortie les signaux périodiques de fréquences souhaitées. Un ILO agit à la fois comme un filtre passe-bande très sélectif et comme un régénérateur de signal, par le biais du verrouillage réalisé sur la fréquence souhaitée.

Les circuits récupérateurs de fréquence 132, 134, 138 et 140 jouent chacun un rôle de filtre passe-bande de très haute sélectivité, et peuvent correspondre chacun à un ILO ou plusieurs circuits ILO disposés en cascade. La réalisation d'un tel ILO est par exemple décrite dans le document « A 50 GHz direct injection locked oscillator topology as low power frequency divider in 0.13 µm CMOS » de M. Tiebout, Solid-State Circuits Conference, 2003. ESSCIRC '03. Proceedings of the 29th European, pp. 73- 76, 16-18 Sept. 2003.

Ainsi, on obtient en sortie du dispositif 100 des signaux S_{LO_IF1}, S_{LO_IF2}, et S_{LO8_CH1} à S_{LO_CHm} de spectre pur, c'est-à-dire comportant une unique raie à la fréquence souhaitée, dont la phase est verrouillée sur celle du signal de référence de fréquence F_{ref}, toutes les autres composantes non désirées ayant été rejetées en dehors des spectres fréquentiels de ces signaux par les circuits récupérateurs de fréquence 132, 134, 138 et 140. Toutefois, la réjection des raies adjacentes à la raie principale n'est pas infinie en pratique. Ainsi, les signaux S_{LO_IF1}, S_{LO_IF2}, et S_{LO_CH1} à S_{LO_CHm} obtenus en sortie des circuits récupérateurs de fréquence 132, 134, 138 et 140 peuvent correspondre non pas à des signaux sinusoïdaux purs, mais à des signaux périodiques dont les spectres fréquentiels présentent chacun une raie principale à la fréquence souhaitée ainsi que des raies secondaires se trouvant à des fréquences multiples de celle de la raie principale. Il est possible d'augmenter cette réjection en reliant en cascade (c'est-à-dire en série) plusieurs ILO et/ou filtres passe-bande pour former chacun des circuits récupérateurs de fréquence 132, 134, 138 et 140, et atténuer ainsi encore plus les raies secondaires des spectres fréquentiels des signaux obtenus en sortie de ces circuits.

La figure 5 représente une variante de réalisation de la première PLL 102. Dans cette variante de réalisation, l'entrée du deuxième diviseur de fréquence 114 n'est pas reliée à la sortie du premier diviseur de fréquence 112, mais est reliée à la sortie de l'oscillateur 110. Dans cette configuration, les fréquences F_{A} et F_{B} sont telles que F_{B} = F_{A}/N1 et F_{ref} = F_{A}/N2 = F_{B}.N1/N2.

La figure 6 représente une variante de réalisation de la deuxième PLL 116. Dans cette variante de réalisation, l'entrée du quatrième diviseur de fréquence 128 n'est pas reliée à la sortie du troisième diviseur de fréquence 126, mais est reliée à la sortie de l'oscillateur 124. Dans cette configuration, les fréquences F₁ et F₂ sont telles que F₂ = F₁/N₃ et F_{ref} = F₁/N4 = F₂.N3/N4.

Les composants des PLL 102 et 116 sont choisis et dimensionnés tels que les fréquences F_{A}, F_{B}, F₁ et F₂ des signaux générés soient adaptées aux canaux des bandes basse et haute de fréquences de transmission utilisés. En effet, en considérant la bande basse de fréquences de transmission, les fréquences F_{A} et F_{B} sont telles que F_{CLA} = F_{A}-F₁+F_{IF} et F_{IF} = F_{B} = F_{A}/N1. La fréquence F_{A} est donc telle que F_{A} = NL.(F_{CLA} + F₁)/(N1 + 1). En considérant la bande haute des fréquences de transmission, les fréquences F_{A} et F_{B} peuvent également être caractérisées telles que F_{CUA} = F_{A}+F₁+F_{IF}, avec toujours F_{IF} = F_{B} = F_{A}/N1. La fréquence F_{A} est donc également telle que F_{A} = N1.(F_{CUA} - F₁)/(N1+ 1). Les valeurs de F_{CLA}, F_{CUA}, F₁ et F₂ correspondent à des spécifications découlant de la configuration des canaux (nombre, largeur) utilisés dans les bandes de fréquences d'émission et de réception. Par exemple, dans le cas d'une transmission de type E-band avec de canaux de largeur égale à 1 GHz ou 2 GHz (correspondant aux exemples décrits en liaison avec la figure 2), ces fréquences sont F_{CLA} = 73,375 GHz, Fcua = 83,375 GHz, F₁ = 5 GHz, et F₂ = 1,25 GHz.

En variante, il est possible que le dispositif 100 comporte, à la place des deux PLL 102 et 116, une seule PLL pour générer les signaux de fréquences F_{A}, F_{B}, F₁ et F₂. Une telle configuration est possible lorsque les valeurs de F, F_{B}, F₁ et F₂ ont un diviseur commun autre que 1.

Les principes ci-dessus s'appliquent lorsque deux canaux sont répartis dans chacune des bandes de fréquences de transmission, mais également lorsque plus de deux canaux sont répartis dans chacune de ces bandes dès lors que leurs fréquences centrales sont distribuées de manière symétrique à l'intérieure de chaque bande de fréquences de transmission. Dans ce cas, le deuxième signal multi-tonalités obtenu en sortie du deuxième élément 136 est utilisé pour générer plus de deux signaux périodiques de fréquences différentes.

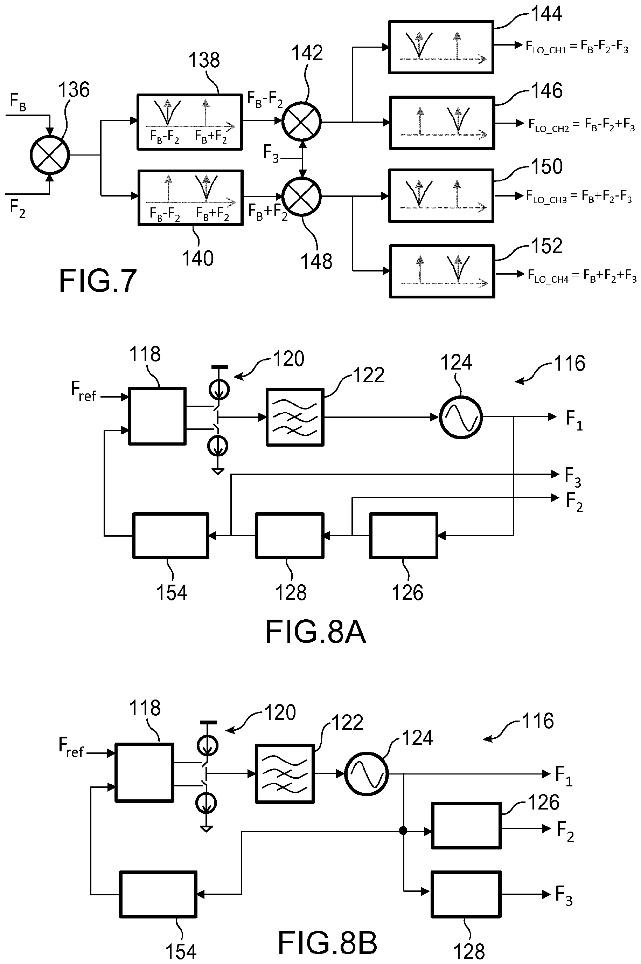

La figure 7 représente une partie du dispositif 100 dans lequel le deuxième signal multi-tonalités obtenu à partir des signaux périodiques de fréquences F_{B} et F₂ permet la génération de plus de deux signaux périodiques de fréquences différentes (quatre sur l'exemple de la figure 7).

Comme dans l'exemple précédemment décrit, les signaux de fréquences F_{B} et F₂ sont appliqués en entrée du deuxième élément 136 (ici un mélangeur). Le deuxième signal multi-tonalités obtenu en sortie du deuxième élément 136 est appliqué en entrée des deux circuits récupérateurs de fréquence 138 et 140 (ici des ILO) délivrant en sortie les signaux de fréquences F_{B}-F₂ et F_{B}+F₂. Le signal délivré en sortie du troisième circuit récupérateur de fréquence 138 est appliqué en entrée d'un troisième élément 142 (ici un mélangeur) réalisant une opération non linéaire entre le signal de fréquence F_{B}-F₂ et un signal périodique (par exemple sinusoïdal) de fréquence F₃ et générant un troisième signal multi-tonalités dont le spectre fréquentiel comporte deux raies principales aux fréquences F_{B}-F₂-F₃ et F_{B}-F₂+F₃. Ce troisième signal multi-tonalités est alors appliqué en entrée d'un cinquième circuit récupérateur de fréquence 144 (ici un ILO) rejetant du spectre fréquentiel les fréquences autres que la fréquence F_{B}-F₂-F₃ et délivrant en sortie un signal périodique de fréquence F_{LO_CH1} = F_{B}-F₂-F₃, ainsi qu'en entrée d'un sixième circuit récupérateur de fréquence 146 rejetant du spectre fréquentiel les fréquences autres que la fréquence F_{B}-F₂+F₃ et délivrant en sortie un signal périodique de fréquence F_{LO_CH2} = F_{B}-F₂+F₃. Parallèlement à cela, le signal délivré en sortie du quatrième circuit récupérateur de fréquence 140 est appliqué en entrée d'un quatrième élément 148 (ici un mélangeur) réalisant une opération non linéaire entre le signal de fréquence F_{B}+F₂ et le signal de fréquence F₃ et générant un quatrième signal multi-tonalités dont le spectre fréquentiel comporte deux raies principales aux fréquences F_{B}+F₂-F₃ et F_{B}+F₂+F₃. Ce quatrième signal multi-tonalités est alors appliqué en entrée d'un septième circuit récupérateur de fréquence 150 (ici un ILO) rejetant du spectre fréquentiel les fréquences autres que la fréquence F_{B}+F₂-F₃ et délivrant en sortie le signal de fréquence F_{LO_CH3} = F_{B}+F₂-F₃, ainsi qu'en entrée d'un huitième circuit récupérateur de fréquence 152 rejetant du spectre fréquentiel les fréquences autres que la fréquence F_{B}+F₂+F₃ et délivrant en sortie le signal de fréquence F_{LO_CH4} = F_{B}+F₂+F₃.

La valeur de F₃ est choisie en fonction des valeurs des fréquences F_{LO_CH1} à F_{LO_CHm} souhaitées.

Si la fréquence F₃ a un diviseur commun avec les fréquences F₁ et F₂, le signal périodique de fréquence F₃ peut être généré à partir de la deuxième PLL 116 qui comporte dans ce cas un diviseur de fréquence 154 supplémentaire réalisant une division de fréquence d'un facteur N5, comme c'est le cas sur les exemples de réalisation de la deuxième PLL 116 représentés sur les figures 8A et 8B. Dans la configuration représentée sur la figure 8A, les fréquences F₁, F₂ et F₃ sont telles que : F₂ = F₁/N3, F₃ = F₂/N4 et F_{ref} = F₃/N5 = F₂/(N4.N5) = F₁/(N3.N4.N5). Dans la configuration représentée sur la figure 8B, les fréquences F₁, F₂ et F₃ sont telles que : F₂ = F₁/N3, F₃ = F₁/N4 et F_{ref} = F₁/N5 = F₂.N3/N5 = F₃.N4/N5.

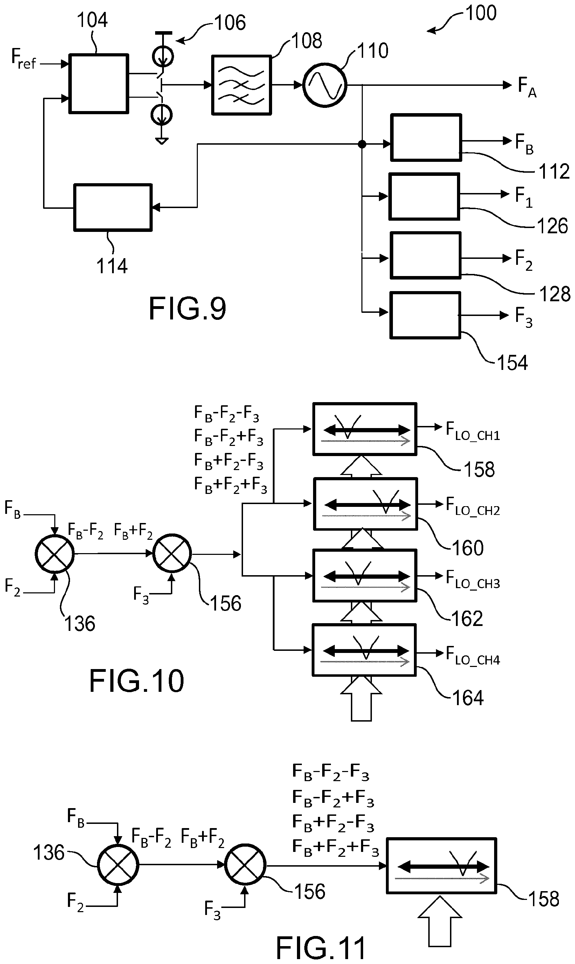

Il est également possible dans ce cas que le dispositif 100 comporte une seule PLL pour générer les signaux de fréquence F_{A}, F_{B}, F₁, F₂ et F₃. Une telle configuration est possible lorsque les valeurs de F_{A}, F_{B}, F₁, F₂ et F₃ ont toutes un diviseur commun. Une telle configuration est représentée sur la figure 9. Dans cette configuration, les valeurs de ces fréquences sont telles que F_{B} = F_{A}/N1, F₁ = F_{A}/N2, F₂ = F_{A}/N3, F₃ = F_{A}/N4, et F_{ref} = F_{A}/N5. D'autres configurations des diviseurs de fréquences 112, 114, 126, 128 et 154 sont possibles tout en n'ayant qu'une seule PLL pour générer ces signaux périodiques.

Si plus de quatre signaux périodiques de fréquences différentes sont destinés à être générés pour la transposition de fréquence entre la bande de fréquences intermédiaires et la bande de base (plus de quatre canaux dans chaque bande de fréquences de transmission), les signaux obtenus en sortie d'au moins une partie des circuits récupérateurs de fréquence 144, 146, 150 et 152 peuvent être de nouveau envoyés en entrée d'un ou plusieurs éléments réalisant des opérations non linéaires afin de générer de nouveaux signaux multi-tonalités à partir desquels un plus grand nombre de signaux périodiques de fréquences différentes peuvent être obtenus en sortie d'autres éléments récupérateurs de fréquence, sur la base du même principe que celui décrit ci-dessus en liaison avec la figure 7.

De manière générale, dans le cas d'un dispositif de type E-band, les différents composants peuvent être dimensionnés de différentes manières, notamment en fonction de la valeur de N1 choisie. Toutefois, toutes les valeurs possibles de N1 ne sont pas judicieuses car il faut tenir compte du fait que la fréquence F_{IF} doit être de préférence supérieure à la largeur des bandes de fréquences de transmission (5 GHz dans le cas de l'E-Band) d'un facteur compris entre environ 3 et 10 afin de faciliter la réalisation du dispositif 100. Cela signifie que les grandes valeurs de N1 peuvent dans ce cas être écartées. En outre, une valeur de N1 trop faible engendre des fréquences F_{A} et F_{B} proches, ce qui est moins intéressant. Le tableau ci-dessous donne les valeurs des fréquences F_{A} et F_{B}, ainsi que le rapport entre la fréquence F_{B} et la largeur de la bande de fréquences intermédiaires (5 GHz dans l'exemple décrit ici), pour différentes valeurs de N1, et pour F_{A} = N1.(F_{CLA} + F₁)/(N1 + 1) avec F_{CLA} = 73,375 GHz et F₁ = 5 GHz.

| N1 | F_{A}(GHz) | F_{B}(GHz) | F_{B}/BW(IF) |
|---|---|---|---|
| 1 | 39,185 | 39,185 | 7,84 |
| 2 | 52,250 | 26,125 | 5,22 |
| 3 | 58,781 | 19,593 | 3,91 |
| 4 | 62,700 | 15,675 | 3,13 |
| 5 | 65,312 | 13,062 | 2,61 |
| 6 | 67,178 | 11,190 | 2,24 |
| 7 | 68,578 | 9,796 | 1,959 |

La valeur de N1 peut être avantageusement choisie telle qu'elle soit égale à 2, 3 ou 4. Par exemple, pour N1 = 4, les valeurs des fréquences centrales de quatre canaux CH1 à CH4 de largeur égale à 1 GHz dans chaque bande de fréquences de transmission et dans la bande de fréquences intermédiaires sont données dans le tableau ci-dessous. En bande de base, les fréquences centrales des canaux sont égales à 0 en émission et en réception.

| | CH1 | CH2 | CH3 | CH4 |
|---|---|---|---|---|
| Fréquence centrale dans la bande de fréquences intermédiaires (GHz) | 13,925 | 14,925 | 16,425 | 17,425 |
| Fréquence centrale dans la bande basse de fréquences de transmission (GHz) | 71,625 | 72,625 | 74,125 | 75,125 |
| Fréquence centrale dans la bande haute de fréquences de transmission (GHz) | 81,625 | 82,625 | 84,125 | 85,125 |

Egalement dans le cas où N1 = 4, les valeurs des fréquences centrales de deux canaux CH1 et CH2 de largeur égale à 2 GHz sont données ci-dessous dans la bande de fréquences intermédiaires et dans les bandes de fréquences de transmission. En bande de base, les fréquences centrales des canaux sont égales à 0 en émission et en réception.

| | CH1 | CH2 |
|---|---|---|
| Fréquence centrale dans la bande de fréquences intermédiaires (GHz) | 14,425 | 16,925 |
| Fréquence centrale dans la bande basse de fréquences de transmission (GHz) | 72,125 | 74,625 |
| Fréquence centrale dans la bande haute de fréquences de transmission (GHz) | 82,125 | 84,625 |

On décrit ci-dessous un exemple de réalisation du dispositif 100 tel que représenté sur la figure 4 réalisant une transmission dans les bandes 71-76 GHz et 81-86 GHz avec des canaux de largeur égale à 2 GHz (deux canaux dans chaque bande de transmission).

Le résonateur génère un signal sinusoïdal de fréquence F_{ref} = 25 MHz. L'oscillateur 110 est un VCO générant un signal sinusoïdal de fréquence F_{A} = 62,7 GHz. Le premier diviseur de fréquence 112 réalise une division d'un facteur N1 = 4 de la fréquence F_{A}, délivrant ainsi en sortie un signal sinusoïdal de fréquence F_{B} = 15,675 GHz. Le deuxième diviseur de fréquence 114 réalise une division de fréquence de facteur N2 = 627, délivrant ainsi en sortie un signal sinusoïdal de fréquence égale à 25 MHz.

La deuxième PLL 116 utilise le même signal de fréquence F_{ref} = 25 MHz que celui utilisé dans la première PLL 102. Le deuxième oscillateur 124 est un VCO générant un signal sinusoïdal de fréquence F₁ = 5 GHz. Le troisième diviseur de fréquence 126 réalise une division d'un facteur N3 = 4 de la fréquence F₁, délivrant ainsi en sortie un signal sinusoïdal de fréquence F₂ = 1,25 GHz. Le quatrième diviseur de fréquence 128 réalise une division de fréquence de facteur N4 = 50, délivrant ainsi en sortie un signal sinusoïdal de fréquence égale à 25 MHz.

Les éléments 130 et 136 sont des mélangeurs. Les signaux de sortie de ces mélangeurs sont envoyés en entrée des circuits récupérateurs de fréquence 132, 134, 138 et 140 correspondant à des ILO. Le premier circuit récupérateur de fréquence 132 délivre en sortie un signal sensiblement sinusoïdal de fréquence F_{LO_IF2} = 57,7 GHz. Le deuxième circuit récupérateur de fréquence 134 délivre en sortie un signal sensiblement sinusoïdal de fréquence F_{LO_IF1} = 67,7 GHz. Le troisième circuit récupérateur de fréquence 138 délivre en sortie un signal sensiblement sinusoïdal de fréquence F_{LO_CH1} = 14,425 GHz. Le quatrième circuit récupérateur de fréquence 140 délivre en sortie un signal sensiblement sinusoïdal de fréquence F_{LO_CH2} = 16,925 GHz.

Pour la réalisation d'un dispositif 100 réalisant une transmission dans les bandes 71 - 76 GHz et 81 - 86 GHz avec des canaux de largeur égale à 1 GHz (quatre canaux dans chaque bande de fréquences de transmission), l'ensemble des éléments décrits ci-dessus sont utilisés et couplés à ceux précédemment décrits en liaison avec la figure 7. Le troisième élément 142 est un mélangeur recevant en entrée le signal de fréquence égale à 14,425 GHz ainsi qu'un signal sinusoïdal de fréquence F₃ = 500 MHz, et le quatrième élément 148 est également un mélangeur recevant en entrée le signal de fréquence égale à 16,925 GHz ainsi que le signal de fréquence F₃. Les signaux de sortie de ces mélangeurs sont envoyés en entrée des autres circuits récupérateurs de fréquence 144, 146, 150 et 152 correspondant à des ILO. Le cinquième circuit récupérateur de fréquence 144 délivre en sortie un signal sensiblement sinusoïdal de fréquence F_{LO_CH1} = 13,925 GHz. Le sixième circuit récupérateur de fréquence 146 délivre en sortie un signal sensiblement sinusoïdal de fréquence F_{LO_CH2} = 14,925 GHz. Le septième circuit récupérateur de fréquence 150 délivre en sortie un signal sensiblement sinusoïdal de fréquence F_{LO_CH3} = 16,425 GHz. Le huitième circuit récupérateur de fréquence 152 délivre en sortie un signal sensiblement sinusoïdal de fréquence F_{LO_CH4} = 17,425 GHz.

Dans les différents exemples et modes de réalisation précédemment décrits, les éléments récupérateurs de fréquence 132 et 134 générant les signaux de fréquence F_{LO_IF2} et F_{LO_IF1} peuvent correspondre à des ILO commutables pouvant se verrouiller sur l'une ou l'autre des deux fréquences du signal multi-tonalités appliqué en entrée de ces éléments, en fonction d'un signal de commande appliqué en entrée de ces ILO commutables. Ainsi, il est possible d'inverser aisément et rapidement les bandes de fréquences utilisées pour l'émission et la réception des données dans le dispositif 1000, ce qui est très avantageux dans le cas de dispositif de transmission de type E-band et autres FDD.

Il est également possible que les éléments de sélection générant les signaux S_{LO_CHi} correspondent à des ILO commutables, c'est-à-dire comportent un mécanisme leur permettant de modifier leur plage de verrouillage, et donc de se verrouiller sur l'une des fréquences du spectre du signal multi-tonalités selon la configuration dans laquelle se trouve chaque ILO commutable. Le signal obtenu en sortie d'un ILO commutable est donc un signal périodique stable en fréquence, par exemple sinusoïdal ou sensiblement sinusoïdal, dont le spectre fréquentiel comporte une seule raie principale à la fréquence souhaitée selon la configuration dans laquelle est mis l'ILO commutable. Cela permet, d'un point de vue fréquentiel, d'intervertir la position des canaux si cela est nécessaire. Lorsque chaque bande de fréquences de transmission comporte plus de deux canaux, par exemple quatre canaux, l'utilisation d'ILO commutables permet de réduire le nombre de composants servant à générer les signaux S_{LO}__{CHi}, comme représenté par exemple sur la figure 10. Contrairement à l'exemple de réalisation précédemment décrit en liaison avec la figure 7 dans lequel le signal de sortie du deuxième élément 136 est appliqué en entrée des troisième et quatrième éléments récupérateurs de fréquence 138 et 140, le signal de sortie du deuxième élément 136 appliqué sur l'entrée d'un autre élément 156, par exemple un mélangeur, réalisant une opération non linéaire entre le signal multi-tonalités comportant les fréquences F_{B}-F₂ et F_{B}+F₂ et le signal de fréquence F₃. Ainsi, le signal multi-tonalités obtenu en sortie de l'élément 156 comporte dans son spectre quatre raies principales aux fréquences F_{LO_CHI}, c'est-à-dire les fréquences F_{B}-F₂-F₃, F_{B}-F₂+F₃, F_{B}+F₂-F₃ et F_{B}+F₂+F₃. Ce signal multi-tonalités est alors appliqué sur l'entrée des quatre ILO commutables 158, 160, 162 et 164 chacun apte à se verrouiller sur l'une de ces fréquences et délivrer en sortie un signal sensiblement sinusoïdal de fréquence égale à l'une de ces quatre fréquences. L'ensemble des positions fréquentielles des canaux peuvent être permutées les unes par rapport aux autres selon la valeur des signaux de commande appliqués sur les entrées de commande de ces ILO commutables. Il est également possible qu'une même fréquence soit sélectionnée par plusieurs des ILO commutables, par exemple dans le cas d'un émetteur ou d'un récepteur travaillant sur un seul canal à la fois qui peut être sélectionné entre les canaux alloués dans la bande couverte par le générateur de fréquences.

Dans les différents exemples de réalisation précédemment décrits, les signaux multi-tonalités comportent des raies principales (correspondant aux fréquences destinées à être récupérées par les circuits récupérateurs de fréquence) d'amplitudes similaires et/ou en phase les unes avec les autres, ce qui permet aux signaux périodiques générés d'avoir des amplitudes et/ou des phases sensiblement constantes quelque soit la fréquence sur laquelle chaque ILO est verrouillé. Le fait que les raies correspondant aux fréquences destinées à être récupérées soient des raies principales du spectre fréquentiel des signaux multi-tonalités (raies de plus grande amplitude par rapport aux raies voisines) facilite le verrouillage des ILO sur ces raies et évite un verrouillage sur une éventuelle autre raie du spectre fréquentiel de ces signaux. La caractéristique selon laquelle les raies principales ont des amplitudes sensiblement similaires peut correspondre à une différence en tension d'environ 4 dB maximum entre ces amplitudes.

L'utilisation d'ILO commutables peut également être envisagée pour la réalisation de canaux de fréquence variable, comme représenté sur la figure 11. Sur cette figure, un seul ILO commutable 158 est utilisé car le dispositif 1000 est destiné à fonctionner avec un seul canal dont la fréquence centrale peut changer. Ainsi, la fréquence du signal de sortie délivré par cet ILO commutable 158 peut correspondre à l'une des quatre fréquences que comporte le signal multi-tonalités délivré par l'élément 156.

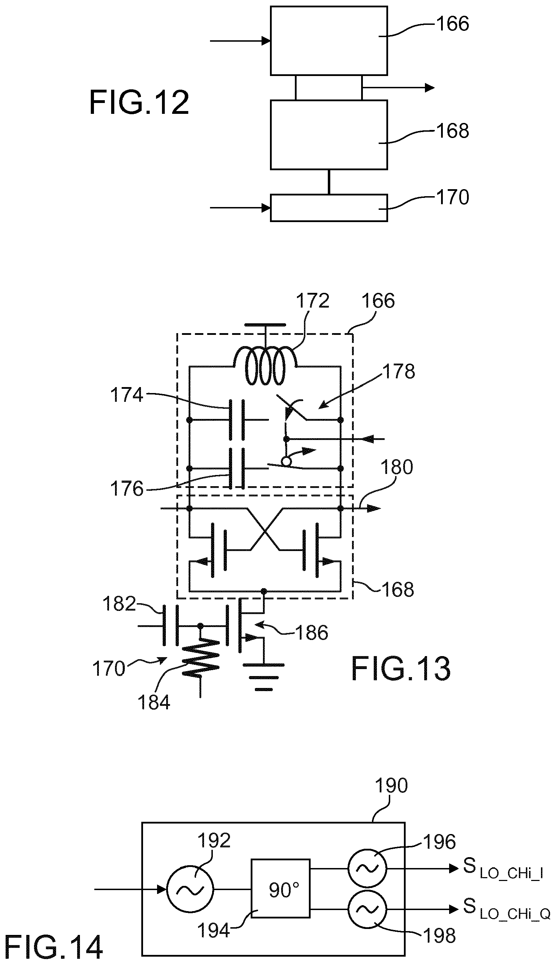

On se réfère maintenant à la figure 12 qui représente schématiquement un ILO commutable formant par exemple l'un des circuits récupérateur de fréquence 132 et 134. L'ILO commutable comporte une structure résonante 166, un élément électrique 168 dont l'impédance électrique est équivalente à celle d'une résistance électrique négative (c'est-à-dire aux bornes de laquelle une tension augmente lorsque le courant qui la traverse diminue, et inversement aux bornes de laquelle une tension diminue lorsque le courant qui la traverse augmente), et un circuit d'injection 170 destiné à recevoir en entrée le signal multi-tonalités comportant les fréquences sur lesquelles l'ILO commutable est destiné à se verrouiller.

La structure résonante 166 peut être configurée selon plusieurs états, chacun étant tel que la valeur de la fréquence d'oscillation libre de l'ILO commutable soit égale ou proche celle de la fréquence sur laquelle l'ILO est destiné à être verrouillé. Le passage, ou la commutation, d'un état à l'autre de la structure résonante 166 est réalisé par l'intermédiaire d'un signal de commande appliqué en entrée de la structure résonante 166.

Lorsqu'aucun signal n'est appliqué à l'entrée du circuit d'injection 170, l'ILO commutable oscille à la fréquence d'oscillation libre dont la valeur dépend de l'état dans lequel se trouve la structure résonante 166. Lorsqu'un signal d'amplitude suffisante et de fréquence proche de la fréquence d'oscillation libre de l'ILO commutable est appliqué à l'entrée du circuit d'injection 170, l'ILO commutable se verrouille alors sur ce signal et la fréquence du signal délivré en sortie par l'ILO commutable ne correspond pas à sa fréquence d'oscillation libre mais est égale à la fréquence du signal appliqué à l'entrée du circuit d'injection 170.

La plage de verrouillage de l'ILO commutable a une forme s'approchant d'un « V » dont la pointe, ou extrémité, se trouve à la fréquence d'oscillation libre de l'ILO commutable. La valeur de la fréquence au niveau de laquelle se situe cette plage de verrouillage dépend de l'état dans lequel l'ILO commutable est mis. L'amplitude requise pour verrouiller l'ILO commutable se réduit à mesure que la fréquence du signal appliqué sur l'entrée du circuit d'injection 170 est proche de la fréquence d'oscillation libre de l'ILO commutable.

La figure 13 représente schématiquement un exemple de réalisation de l'ILO commutable. Dans cet exemple, l'ILO commutable peut être configuré dans deux états, et la fréquence du signal délivré par cet ILO peut correspondre à l'une de deux fréquences présentes dans le signal multi-tonalités appliqué en entrée de l'ILO. La structure résonante 166 comporte une inductance 172 couplée en parallèle à un premier condensateur 174 et à un deuxième condensateur 176. La valeur de la capacité électrique du premier condensateur 174 est différente de celle du deuxième condensateur 176. La structure résonante 166 comporte également deux interrupteurs 178 fonctionnant de manière complémentaire l'un par rapport à l'autre (l'un des deux interrupteurs étant en position fermée lorsque l'autre des deux interrupteurs est en position ouverte). Les interrupteurs 178 sont commandés par le signal de commande appliqué en entrée de la structure résonante 166. Ainsi, la structure résonante 166 forme un circuit résonant LC qui comporte, dans le premier état, l'inductance 172 et le premier condensateur 174, et dans le deuxième état, l'inductance 172 et le deuxième condensateur 176. Le circuit résonant LC formé par la structure résonante 166 comporte donc le premier condensateur 174 ou le deuxième condensateur 176 selon la valeur du signal de commande appliqué en entrée de la structure résonante 166, et la fréquence d'oscillation libre de l'ILO commutable est donc modifiée selon les éléments formant ce circuit résonant LC.

En variante, la structure résonante 166 peut comporter un unique condensateur couplé à une première inductance dans le premier état et à une deuxième inductance dans le deuxième état, les valeurs de ces deux inductances étant différentes.

Dans une autre variante, il est également possible que la structure résonante 166 comporte une première et une deuxième inductances de valeurs différentes, et un premier et un deuxième condensateurs présentant des capacités de valeurs différentes, la première inductance étant couplée électriquement au premier condensateur dans le premier état, et la deuxième inductance étant couplée électriquement au deuxième condensateur dans le deuxième état.

Dans les exemples de réalisation précédemment décrits en liaison avec les figures 10 et 11, chacun des ILO commutables 158, 160, 162 et 164 peut être configuré selon quatre états différents. Pour cela, la structure résonante de chacun de ces ILO peut comporter l'inductance 172 ainsi que quatre condensateurs pouvant être chacun couplé avec l'inductance 172 selon l'état dans lequel l'ILO commutable est configuré, ou bien comporter quatre inductances de valeurs différentes pouvant être couplées à un condensateur, voir quatre inductances et quatre condensateurs.

L'élément électrique 168 correspond à une paire croisée différentielle de type MOS, ici formée par deux transistors NMOS au niveau desquels se trouve une sortie 180 de l'ILO commutable.

Le circuit d'injection 170 comporte une capacité 182 de blocage de courant continu couplée à une résistance 184. Le premier signal périodique est destiné à être appliqué sur une première borne de la capacité 182. Une tension de polarisation, définissant le courant de polarisation de l'élément 168, est appliquée sur une première borne de la résistance 184, et une deuxième borne de la résistance 184 est reliée à une deuxième borne de la capacité 182 et à la grille d'un troisième transistor NMOS 186. Le drain du troisième transistor NMOS 186 est relié à l'élément électrique 168.

En variante, le troisième transistor NMOS 186 peut comporter sa source et son drain reliés en parallèle à la structure résonante 166.

Selon une autre variante, le circuit d'injection 170 peut comporter, à la place du troisième transistor NMOS 186, deux transistors MOS dont les drains sont reliés aux drains des deux transistors MOS de l'élément électrique 168 et dont les sources sont reliées à une source de courant de polarisation. Dans cette variante, le circuit d'injection 170 comporte également la capacité 182 couplée à la résistance 184 de manière analogue à la configuration précédemment décrite en liaison avec la figure 13. Le signal multi-tonalités est destiné à être appliqué sur la première borne de la capacité 182 et une tension de polarisation est destinée à être appliquée sur la première borne de la résistance 184, la deuxième borne de la résistance 184 étant reliée à la deuxième borne de la capacité 182 et aux grilles des deux transistors MOS du circuit d'injection 170 (le signal multi-tonalités étant dans ce cas un signal différentiel).

Les valeurs de la ou des inductances et de la ou des capacités électriques des condensateurs de la structure résonante 166 sont choisies telles que la fréquence d'oscillation libre de l'ILO commutable dans l'état choisi soit proche ou égale à la fréquence sur laquelle l'ILO est destiné à se verrouiller. Ainsi, l'ILO commutable qui reçoit en entrée un signal multi-tonalités comportant au moins deux raies principales à des fréquences différentes délivre en sortie un signal périodique stable en fréquence et de fréquence égale à l'une des fréquences des raies principales du signal multi-tonalités selon l'état dans lequel se trouve la structure résonante de l'ILO commutable. La fréquence du signal de sortie de l'ILO commutable peut être facilement et rapidement commutée entre ces différentes fréquences en changeant l'état dans lequel se trouve la structure résonante. L'ILO commutable se comporte comme un filtre passe-bande très sélectif par le biais du verrouillage réalisé sur la fréquence souhaitée.

Dans une autre variante de réalisation, il est possible que les circuits récupérateurs de fréquence générant les signaux S_{LO}__{CHi} soient tels que, en sortie de chacun de ces circuits, deux signaux S_{LO}__{CHi_I} et S_{LO}__{CHi_Q} de même fréquence et de même amplitude, mais qui présentent entre eux un déphasage de 90°, c'est-à-dire l'un en phase avec le signal appliqué en entrée du circuit récupérateur de fréquence et l'autre en quadrature de phase par rapport à ce signal (signaux I/Q). Une telle variante peut notamment être utilisée au sein d'une architecture multicanaux réalisant une conversion directe d'une bande de fréquences intermédiaires à la bande de base.

La figure 14 représente un exemple de réalisation d'un circuit récupérateur de fréquence 190 permettant de délivrer en sortie de tels signaux. Le circuit 190 reçoit en entrée le signal multi-tonalités comportant dans son spectre la fréquence F_{LO}__{CHi} correspondant par exemple l'une des deux fréquences F_{B}-F₂ et F_{B}+F₂. Le circuit 190 comporte un premier ILO 192 dont l'entrée reçoit le signal multi-tonalités et dont la sortie est reliée à l'entrée d'un élément déphaseur 194 de type actif ou passif permettant de reproduire sur l'une de ses deux sorties le signal appliqué en entrée et de générer sur l'autre de ses deux sorties le signal appliqué en entrée déphasé de 90°. Chacun de ces deux signaux sont appliqués en entrées de deux autres ILO 196 et 198 délivrant en sortie les signaux S_{LO_CHi_I} et S_{LO_CHi_Q}. Les deux ILO 196 et 198 fonctionnent soit de manière indépendante l'un de l'autre, soit de manière couplée telle que les sorties des deux ILO 196 et 198 soient déphasées l'une de l'autre de 90° sans faire appel à l'élément déphaseur 194. Le fonctionnement d'un tel élément de type Quadrature VCO (QVCO) est par exemple décrit dans le document « A 17.5-to-20.94GHz and 35-to-41.88GHz PLL in 65nm CMOS for wireless HD applications » de O. Richard et al., Solid-States Circuits Conference Digest of Technical Papers (ISSCC), 2010 IEEE International, pages 252-253, 7-11 Feb. 2010.

Le dispositif 1000 précédemment décrit peut correspondre à un dispositif de transmission radiofréquence. Le dispositif 1000 peut également être un dispositif émetteur - récepteur de type électro-optique apte à envoyer des données via un multiplexage en longueurs d'ondes (WDM), c'est-à-dire en modulant plusieurs longueurs d'ondes envoyées via un même guide d'onde optique, chaque longueur d'onde optique correspondant à une fréquence d'oscillation du champ électromagnétique présent dans le guide d'onde. Une autre manière d'exploiter une grande largeur de bande optique consiste à appliquer une modulation large bande à une seule longueur d'onde optique. L'OFDM correspond à ce type de modulation dans laquelle plusieurs sous-porteuses électriques ayant des fréquences différentes sont modulées individuellement par différents signaux en bande de base puis combinés et transposés autour de la fréquence optique. Un dispositif 1000 tel que décrit précédemment peut donc correspondre à un tel dispositif émetteur - récepteur électro-optique de type OFDM utilisant les sous-porteuses de fréquences différentes. Chacune de ces fréquences est dans ce cas modulée avec un flux de données différent puis transposée en fréquence dans le domaine optique en utilisant un modulateur ou un laser afin de fournir un signal optique OFDM.

## Revendications

1. Dispositif (1000) d'émission et/ou de réception de signaux destinés à être transmis dans au moins deux bandes de fréquences de transmission (1004, 1006) symétriques par rapport à une première fréquence de symétrie F_{CA} et telles que chacune des deux bandes de fréquences de transmission (1004, 1006) comporte au moins deux canaux (10, 12), ou groupes de canaux (20, 22, 24, 26), symétriques par rapport à des deuxièmes fréquences de symétrie F_{CLA}, F_{CUA}, comportant au moins :
- des premiers moyens (102, 116) aptes à générer un signal périodique de fréquence F_{A}, un signal périodique de fréquence F_{B} = F_{A}/N1, un signal périodique de fréquence F₁ égale à |F_{CA} - F_{CLA}| et un signal périodique de fréquence F₂ égale à la différence entre une fréquence centrale d'un des canaux ou groupes de canaux et la deuxième fréquence de symétrie associée au dit un des canaux ou groupes de canaux, et dans lequel F_{A} = N1.(F_{CLA} + F₁)/(N1 + 1) avec N1 nombre supérieur à 1 ;
- des deuxième moyens (130 - 152, 156 - 164) aptes à réaliser une première opération non linéaire entre les signaux périodiques de fréquences F_{A} et F₁ générant un premier signal multi-tonalités dont le spectre fréquentiel comporte deux raies principales aux fréquences F_{A}-F₁ et F_{A}+F₁, et aptes à réaliser une deuxième opération non linéaire entre les signaux périodiques de fréquences F_{B} et F₂ générant un deuxième signal multi-tonalités dont le spectre fréquentiel comporte deux raies principales aux fréquences F_{B}-F₂ et F_{B}+F₂.

2. Dispositif (1000) selon la revendication 1, dans lequel les deuxièmes moyens comportent au moins un premier mélangeur (130) apte à réaliser la première opération non linéaire et un deuxième mélangeur (136) apte à réaliser la deuxième opération non linéaire.

3. Dispositif (1000) selon l'une des revendications précédentes, dans lequel les premiers moyens comportent une première boucle à verrouillage de phase (102) apte à délivrer en sortie les signaux périodiques de fréquences F_{A} et F_{B} et une deuxième boucle à verrouillage de phase (116) apte à délivrer en sortie les signaux périodiques de fréquences F₁ et F₂, ou, lorsque la fréquence F_{A} correspond à un multiple entier de chacune des fréquences F_{B}, F₁ et F₂, les premiers moyens comportent une seule boucle à verrouillage de phase apte à délivrer en sortie les signaux périodiques de fréquences F_{A}, F_{B}, F₁ et F₂.

4. Dispositif (1000) selon l'une des revendications précédentes, comportant en outre au moins :
- des premier et deuxième circuits récupérateurs de fréquence (132, 134) recevant en entrée le premier signal multi-tonalités et délivrant chacun en sortie un signal périodique respectivement de fréquence F_{A}-F₁ et F_{A}+F₁ ;
- des troisième et quatrième circuits récupérateurs de fréquence (138, 140) recevant en entrée le deuxième signal multi-tonalités et délivrant chacun en sortie un signal périodique respectivement de fréquence F_{B}-F₂ et F_{B}+F₂.

5. Dispositif (1000) selon la revendication 4, comportant en outre, lorsque chacune des deux bandes de fréquences de transmission (1004, 1006) comporte au moins deux groupes d'au moins deux canaux, des troisièmes moyens (142, 148) aptes à réaliser une troisième opération non linéaire entre le signal périodique de fréquence F_{B}-F₂ et un signal périodique de fréquence F₃ générant un troisième signal multi-tonalités dont le spectre fréquentiel comporte deux raies principales aux fréquences F_{B}-F₂-F₃ et F_{B}-F₂+F₃, et aptes à réaliser une quatrième opération non linéaire entre les signaux périodiques de fréquences F_{B}+F₂ et F₃ générant un quatrième signal multi-tonalités dont le spectre fréquentiel comporte deux raies principales aux fréquences F_{B}+F₂-F₃ et F_{B}+F₂+F₃.

6. Dispositif (1000) selon la revendication 5, comportant en outre au moins :
- des cinquième et sixième circuits récupérateurs de fréquence (144, 146) recevant en entrée le troisième signal multi-tonalités et délivrant chacun en sortie un signal périodique respectivement de fréquence F_{B}-F₂-F₃ et F_{B}-F₂+F₃ ;
- des septième et huitième circuits récupérateurs de fréquence (150, 152) recevant en entrée le quatrième signal multi-tonalités et délivrant chacun en sortie un signal périodique de fréquence F_{B}+F₂-F₃ et F_{B}+F₂+F₃.

7. Dispositif (1000) selon l'une des revendications 4 à 6, dans lequel chaque circuit récupérateur de fréquence (132, 134, 138, 140, 144, 146, 150, 152) comporte au moins un oscillateur verrouillé par injection et/ou un filtre passe-bande.

8. Dispositif (1000) selon l'une des revendications 1 à 3, comportant en outre :
- des premier et deuxième circuits récupérateurs de fréquence (132, 134) recevant en entrée le premier signal multi-tonalités et délivrant chacun en sortie un signal périodique respectivement de fréquence F_{A}-F₁ et F_{A}+F₁ ;
- des quatrièmes moyens (156) aptes à réaliser une troisième opération non linéaire entre le deuxième signal multi-tonalités et un signal périodique de fréquence F₃ générant un cinquième signal multi-tonalités dont le spectre comporte quatre raies principales aux fréquences F_{B}-F₂-F₃, F_{B}-F₂+F₃, F_{B}+F₂-F₃ et F_{B}+F₂+F₃ ;
- au moins un oscillateur verrouillé par injection commutable (158, 160, 162, 164) recevant en entrée le cinquième signal multi-tonalités et délivrant en sortie au moins un signal périodique de fréquence égale à l'une des fréquences F_{B}-F₂-F₃, F_{B}-F₂+F₃, F_{B}+F₂-F₃ et F_{B}+F₂+F₃.

9. Dispositif (1000) selon l'une des revendications précédentes, comportant en outre :
- un étage de conversion entre les bandes de fréquences de transmission (1004, 1006) et une bande de fréquences intermédiaires (1012), comprenant au moins un troisième mélangeur (1014) apte à recevoir en entrée un signal reçu par le dispositif (1000) dans l'une des deux bandes de fréquences de transmission (1006) et l'un des deux signaux périodiques de fréquences F_{A}-F₁ et F_{A}+F₁ et au moins un quatrième mélangeur (1028) apte à recevoir en entrée un signal en bande de fréquences intermédiaires (1012) destiné à être émis par le dispositif (1000) dans l'autre des deux bandes de fréquences de transmission (1004) et l'autre des deux signaux périodiques de fréquences F_{A}-F₁ et F_{A}+F₁ ;
- un étage de conversion entre la bande de fréquences intermédiaires (1012) et une bande de base, comprenant une pluralité de cinquièmes mélangeurs (1016.1 - 1016.m) aptes à recevoir chacun en entrée un signal de sortie du troisième mélangeur (1014) et l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃, et une pluralité de sixièmes mélangeurs (1026.1 - 1026.m) aptes à recevoir chacun en entrée un signal en bande de base destiné à être émis par le dispositif (1000) dans ladite autre des deux bandes de fréquences de transmission (1004) et l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃.

10. Procédé d'émission et/ou de réception de signaux dans au moins deux bandes de fréquences de transmission (1004, 1006) symétriques par rapport à une première fréquence de symétrie F_{CA} et telles que chacune des deux bandes de fréquences de transmission (1004, 1006) comporte au moins deux canaux (10, 12), ou groupes de canaux (20, 22, 24, 26), symétriques par rapport à des deuxièmes fréquences de symétrie F_{CLA}, F_{CUA}, comportant au moins les étapes de :
- génération d'un signal périodique de fréquence F_{A}, d'un signal périodique de fréquence F_{B} = F_{A}/N1, d'un signal périodique de fréquence F₁ égale à |F_{CA} - F_{CLA}| et d'un signal périodique de fréquence F₂ égale à la différence entre une fréquence centrale d'un des canaux ou groupe de canaux et la deuxième fréquence de symétrie associée au dit un des canaux ou groupe de canaux, et dans lequel F_{A} = NL.(F_{CLA} + F₁)/(N1 + 1) avec N1 nombre supérieur à 1 ;
- réalisation d'une première opération non linéaire entre les signaux périodiques de fréquences F_{A} et F₁ générant un premier signal multi-tonalités dont le spectre fréquentiel comporte deux raies principales aux fréquences F_{A}-F₁ et F_{A}+F₁, et d'une deuxième opération non linéaire entre les signaux périodiques de fréquence F_{B} et F₂ générant un deuxième signal multi-tonalités dont le spectre fréquentiel comporte deux raies principales aux fréquences F_{B}-F₂ et F_{B}+F₂.

11. Procédé selon la revendication 10, comportant en outre les étapes de :
- génération de signaux périodiques de fréquences F_{A}-F₁ et F_{A}+F₁ à partir du premier signal multi-tonalités ;
- génération de signaux périodiques de fréquences F_{B}-F₂ et F_{B}+F₂ à partir du deuxième signal multi-tonalités.

12. Procédé selon la revendication 11, comportant en outre, lorsque chacune des deux bandes de fréquences de transmission (1004, 1006) comporte au moins deux groupes d'au moins deux canaux, la réalisation d'une troisième opération non linéaire entre le signal périodique de fréquence F_{B}-F₂ et un signal périodique de fréquence F₃ générant un troisième signal multi-tonalités dont le spectre fréquentiel comporte deux raies principales aux fréquences F_{B}-F₂-F₃ et F_{B}-F₂+F₃, et d'une quatrième opération non linéaire entre les signaux périodiques de fréquences F_{B}+F₂ et F₃ générant un quatrième signal multi-tonalités dont le spectre comporte deux raies principales aux fréquences F_{B}+F₂-F₃ et F_{B}+F₂+F₃.

13. Procédé selon la revendication 12, comportant en outre les étapes de :
- génération de signaux périodiques de fréquences F_{B}-F₂-F₃ et F_{B}-F₂+F₃ à partir du troisième signal multi-tonalités ;
- génération de signaux périodiques de fréquences F_{B}+F₂-F₃ et F_{B}+F₂+F₃ à partir du quatrième signal multi-tonalités.

14. Procédé selon la revendication 10, comportant en outre les étapes de :
- génération de signaux périodiques de fréquences F_{A}-F₁ et F_{A}+F₁ à partir du premier signal multi-tonalités ;
- réalisation d'une troisième opération non linéaire entre le deuxième signal multi-tonalités et un signal périodique de fréquence F₃ générant un cinquième signal multi-tonalités dont le spectre comporte quatre raies principales aux fréquences F_{B}-F₂-F₃, F_{B}-F₂+F₃, F_{B}+F₂-F₃ et F_{B}+F₂+F₃ ;
- génération d'au moins un signal périodique de fréquence égale à l'une des fréquences F_{B}-F₂-F₃, F_{B}-F₂+F₃, F_{B}+F₂-F₃ et F_{B}+F₂+F₃ à partir du cinquième signal multi-tonalités.

15. Procédé selon l'une des revendications 10 à 14, comportant en outre :
- lors d'une réception d'un signal dans l'une des deux bandes de fréquences de transmission (1006), une première transposition dans une bande de fréquences intermédiaires (1012) du signal reçu en utilisant l'un des deux signaux périodiques de fréquences F_{A}-F₁ et F_{A}+F₁, puis une deuxième transposition en bande de base du signal issu de la première transposition en utilisant l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃, et
- lors d'une émission d'un signal dans l'autre des deux bandes de fréquences de transmission (1004), une première transposition dans la bande de fréquences intermédiaires (1012) d'un signal en bande de base en utilisant l'un des signaux périodiques de fréquences F_{B}-F₂, F_{B}+F₂, F_{B}-F₂-F₃, F_{B}-F₂+F₃, F_{B}+F₂-F₃ et F_{B}+F₂+F₃, puis une deuxième transposition dans l'autre des deux bandes de fréquences de transmission (1004) du signal issu de la première transposition en utilisant l'autre des deux signaux périodiques de fréquences F_{A}-F₁ et F_{A}+F₁.

## Patentansprüche

1. Vorrichtung (1000) zum Senden und/oder zum Empfangen von Signalen, die in wenigstens zwei Übertragungsfrequenzbändern (1004, 1006) übertragen werden sollen, die bezüglich einer ersten Symmetriefrequenz F_{CA} symmetrisch und derart sind, dass jedes der zwei Übertragungsfrequenzbänder (1004, 1006) wenigstens zwei Kanäle (10, 12) oder Gruppen von Kanälen (20, 22, 24, 26) umfasst, die bezüglich zweiter Symmetriefrequenzen F_{CLA}, F_{CUA} symmetrisch sind, umfassend wenigstens:
- erste Mittel (102, 116), die dazu ausgelegt sind, ein periodisches Signal der Frequenz F_{A} zu erzeugen, ein periodisches Signal der Frequenz F_{B} = F_{A}/N1, ein periodisches Signal der Frequenz F₁ gleich |F_{CA} - F_{CLA}| sowie ein periodisches Signal der Frequenz F₂ gleich der Differenz zwischen einer Zentralfrequenz eines der Kanäle oder Gruppen von Kanälen und der zweiten Symmetriefrequenz, die dem einen der Kanäle oder Gruppen von Kanälen zugeordnet ist, und wobei F_{A} = N1.(F_{CLA} + F₁)/(N1 + 1), wobei N1 eine Zahl größer als 1 ist;
- zweite Mittel (130-152, 156-164), die dazu ausgelegt sind, eine erste nichtlineare Operation zu realisieren zwischen den periodischen Signalen der Frequenzen F_{A} und F₁ zur Erzeugung eines ersten Multitonalitätssignals, dessen Frequenzspektrum zwei Hauptlinien bei den Frequenzen F_{A}-F₁ und F_{A}+ F₁ umfasst, und dazu ausgelegt sind, eine zweite nichtlineare Operation zu realisieren zwischen den periodischen Signalen der Frequenzen F_{B} und F₂ zur Erzeugung eines zweiten Multitonalitätssignals, dessen Frequenzspektrum zwei Hauptlinien bei den Frequenzen F_{B}-F₂ und F_{B}+F₂ umfasst.

2. Vorrichtung (1000) nach Anspruch 1, wobei die zweiten Mittel wenigstens einen ersten Mischer (130) umfassen, der dazu ausgelegt ist, die erste nichtlineare Operation zu realisieren, und einen zweiten Mischer (136), der dazu ausgelegt ist, die zweite nichtlineare Operation zu realisieren.

3. Vorrichtung (1000) nach einem der vorhergehenden Ansprüche, wobei die ersten Mittel eine erste Phasenverriegelungsschleife (102) umfassen, die dazu ausgelegt ist, am Ausgang die periodischen Signale der Frequenzen F_{A} und F_{B} zu liefern, und eine zweite Phasenverriegelungsschleife (116), die dazu ausgelegt ist, am Ausgang die periodischen Signale der Frequenzen F₁ und F₂ zu liefern, oder, wenn die Frequenz F_{A} einem ganzzahligen Vielfachen jeder der Frequenzen F_{B}, F₁ und F₂ entspricht, die ersten Mittel eine einzige Phasenverriegelungsschleife umfassen, die dazu ausgelegt ist, am Ausgang die periodischen Signale der Frequenzen F_{A}, F_{B}, F₁ und F₂ zu liefern.

4. Vorrichtung (1000) nach einem der vorhergehenden Ansprüche, ferner umfassend wenigstens:
- einen ersten und einen zweiten Frequenzwiedergewinnungskreis (132, 134), die am Eingang das erste Multitonalitätssignal empfangen und jeweils am Ausgang ein periodisches Signal der Frequenz F_{A}-F₁ beziehungsweise F_{A}+F₁ liefern;
- einen dritten und einen vierten Frequenzwiedergewinnungskreis (138, 140), die am Eingang das zweite Multitonalitätssignal empfangen und jeweils am Ausgang ein periodisches Signal der Frequenz F_{B}-F₂ beziehungsweise F_{B}+F₂ liefern.

5. Vorrichtung (1000) nach Anspruch 4, ferner umfassend, wenn jedes der zwei Übertragungsfrequenzbänder (1004, 1006) wenigstens zwei Gruppen von wenigstens zwei Kanälen umfasst, dritte Mittel (142, 148), die dazu ausgelegt sind, eine dritte nichtlineare Operation zu realisieren zwischen dem periodischen Signal der Frequenz F_{B}-F₂ und einem periodischen Signal der Frequenz F₃ zur Erzeugung eines dritten Multitonalitätssignals, dessen Frequenzspektrum zwei Hauptlinien bei den Frequenzen F_{B}-F₂-F₃ und F_{B}-F₂+F₃ umfasst, und dazu ausgelegt sind, eine vierte nichtlineare Operation zu realisieren zwischen den periodischen Signalen der Frequenzen F_{B}+F₂ und F₃ zur Erzeugung eines vierten Multitonalitätssignals, dessen Frequenzspektrum zwei Hauptlinien bei den Frequenzen F_{B}+F₂-F₃ und F_{B}+F₂+F₃ umfasst.

6. Vorrichtung (1000) nach Anspruch 5, ferner umfassend wenigstens:
- einen fünften und einen sechsten Frequenzwiedergewinnungskreis (144, 146), die am Eingang das dritte Multitonalitätssignal empfangen und jeweils am Ausgang ein periodisches Signal der Frequenz F_{B}-F₂-F₃ beziehungsweise F_{B}-F₂+F₃ liefern;
- einen siebten und einen achten Frequenzwiedergewinnungskreis (150, 152), die am Eingang das vierte Multitonalitätssignal empfangen und jeweils am Ausgang ein periodisches Signal der Frequenz F_{B}+F₂-F₃ beziehungsweise F_{B}+F₂+F₃ liefern.

7. Vorrichtung (1000) nach einem der Ansprüche 4 bis 6, wobei jeder Frequenzwiedergewinnungskreis (132, 134, 138, 140, 144, 146, 150, 152) wenigstens einen injektionsverriegelten Oszillator und/oder ein Bandpassfilter umfasst.

8. Vorrichtung (1000) nach einem der Ansprüche 1 bis 3, ferner umfassend:
- einen ersten und einen zweiten Frequenzwiedergewinnungskreis (132, 134), die am Eingang das erste Multitonalitätssignal empfangen und jeweils am Ausgang ein periodisches Signal der Frequenz F_{A}-F₁ beziehungsweise F_{A}+F₁ liefern;
- vierte Mittel (156), die dazu ausgelegt sind, eine dritte nichtlineare Operation zu realisieren zwischen dem zweiten Multitonalitätssignal und einem periodischen Signal der Frequenz F₃ zur Erzeugung eines fünften Multitonalitätssignals, dessen Spektrum vier Hauptlinien bei den Frequenzen F_{B}-F₂-F₃, F_{B}-F₂+F₃, F_{B}+F₂-F₃ und F_{B}+F₂+F₃ umfasst;
- wenigstens einen schaltbaren injektionsverriegelten Oszillator (158, 160, 162, 164), der am Eingang das fünfte Multitonalitätssignal empfängt und am Ausgang wenigstens ein periodisches Signal der Frequenz gleich einer der Frequenzen F_{B}-F₂-F₃, F_{B}-F₂+F₃, F_{B}+F₂-F₃ und F_{B}+F₂+F₃ liefert.

9. Vorrichtung (1000) nach einem der vorhergehenden Ansprüche, ferner umfassend:
- eine Wandlerstufe zwischen den Übertragungsfrequenzbändern (1004, 1006) und einem Zwischenfrequenzband (1012), umfassend wenigstens einen dritten Mischer (1014), der dazu ausgelegt ist, am Eingang ein Signal zu empfangen, das durch die Vorrichtung (1000) in einem der zwei Übertragungsfrequenzbänder (1006) empfangen ist, und eines der zwei periodischen Signale der Frequenzen F_{A}-F₁ und F_{A}+F₁, sowie wenigstens einen vierten Mischer (1028), der dazu ausgelegt ist, am Eingang ein Signal im Zwischenfrequenzband (1012) zum empfangen, das durch die Vorrichtung (1000) in dem anderen der zwei Übertragungsfrequenzbänder (1004) gesendet werden soll, und das andere der zwei periodischen Signale der Frequenzen F_{A}-F₁ und F_{A}+F₁;
- eine Wandlerstufe zwischen dem Zwischenfrequenzband (1012) und einem Basisband, umfassend eine Mehrzahl von fünften Mischern (1016.1-1016.m), die dazu ausgelegt sind, jeweils am Eingang ein Ausgangssignal des dritten Mischers (1014) und eines der periodischen Signale der Frequenzen F_{B}-F₂, F_{B}+F₂, F_{B}-F₂-F₃, F_{B}-F₂+F₃, F_{B}+F₂-F₃ und F_{B}+F₂+F₃ zu empfangen, und eine Mehrzahl von sechsten Mischern (1026.1-1026.m), die dazu ausgelegt sind, jeweils am Eingang ein Signal im Basisband zu empfangen, das durch die Vorrichtung (1000) in dem anderen der zwei Übertragungsfrequenzbänder (1004) gesendet werden soll, und eines der periodischen Signale der Frequenzen F_{B}-F₂, F_{B}+F₂, F_{B}-F₂-F₃, F_{B}-F₂+F₃, F_{B}+F₂-F₃ und F_{B}+F₂+F₃.

10. Verfahren zum Senden und/oder zum Empfangen von Signalen in wenigstens zwei Übertragungsfrequenzbändern (1004, 1006), die bezüglich einer ersten Symmetriefrequenz F_{CA} symmetrisch sind, und derart, dass jedes der zwei Übertragungsfrequenzbänder (1004, 1006) wenigstens zwei Kanäle (10, 12) oder Gruppen von Kanälen (20, 22, 24, 26) umfasst, die bezüglich zweiter Symmetriefrequenzen F_{CLA}, F_{CUA} symmetrisch sind, umfassend wenigstens die folgenden Schritte:
- Erzeugen eines periodischen Signals der Frequenz F_{A}, eines periodischen Signals der Frequenz F_{B} = F_{A}/N1, eines periodischen Signals der Frequenz F₁ gleich |F_{CA} - F_{CLA}|, und eines periodischen Signals der Frequenz F₂ gleich der Differenz zwischen einer Zentralfrequenz eines der Kanäle oder Gruppe von Kanälen und der zweiten Symmetriefrequenz, die dem einen der Kanäle oder Gruppe von Kanälen zugeordnet ist, und wobei F_{A} = N1.(F_{CLA} + F₁)/(N1 + 1), wobei N1 eine Zahl größer als 1 ist;
- Realisieren einer ersten nichtlinearen Operation zwischen den periodischen Signalen der Frequenzen F_{A} und F₁ zur Erzeugung eines ersten Multitonalitätssignals, dessen Frequenzspektrum zwei Hauptlinien bei den Frequenzen F_{A}-F₁ und F_{A}+ F₁ umfasst, und einer zweiten nichtlinearen Operation zwischen den periodischen Signalen der Frequenz F_{B} und F₂ zur Erzeugung eines zweiten Multitonalitätssignals, dessen Frequenzspektrum zwei Hauptlinien bei den Frequenzen F_{B}-F₂ und F_{B}+F₂ umfasst.

11. Verfahren nach Anspruch 10, ferner umfassend die folgenden Schritte:
- Erzeugen von periodischen Signalen der Frequenzen F_{A}-F₁ und F_{A}+F₁ ausgehend von dem ersten Multitonalitätssignal;
- Erzeugen von periodischen Signale der Frequenzen F_{B}-F₂ und F_{B}+F₂ ausgehend von dem zweiten Multitonalitätssignal.

12. Verfahren nach Anspruch 11, ferner umfassend, wenn jedes der zwei Übertragungsfrequenzbänder (1004, 1006) wenigstens zwei Gruppen von wenigstens zwei Kanälen umfasst, die Realisierung einer dritten nichtlinearen Operation zwischen dem periodischen Signal der Frequenz F_{B}-F₂ und einem periodischen Signal der Frequenz F₃ zur Erzeugung eines dritten Multitonalitätssignals, dessen Frequenzspektrum zwei Hauptlinien bei den Frequenzen F_{B}-F₂-F₃ und F_{B}-F₂+F₃ umfasst, und einer vierten nichtlinearen Operation zwischen den periodischen Signalen der Frequenzen F_{B}+F₂ und F₃ zur Erzeugung eines vierten Multitonalitätssignals, dessen Spektrum zwei Hauptlinien bei den Frequenzen F_{B}+F₂-F₃ und F_{B}+F₂+F₃ umfasst.

13. Verfahren nach Anspruch 12, ferner umfassend die folgenden Schritte:
- Erzeugen von periodischen Signalen der Frequenzen F_{B}-F₂-F₃ und F_{B}-F₂+F₃ ausgehend von dem dritten Multitonalitätssignal;
- Erzeugen von periodischen Signalen der Frequenzen F_{B}+F₂-F₃ und F_{B}+F₂+F₃ ausgehend von dem vierten Multitonalitätssignal.

14. Verfahren nach Anspruch 10, ferner umfassend die folgenden Schritte:
- Erzeugen von periodischen Signalen der Frequenzen F_{A}-F₁ und F_{A}+F₁ ausgehend von dem ersten Multitonalitätssignal;
- Realisieren einer dritten nichtlinearen Operation zwischen dem zweiten Multitonalitätssignal und einem periodischen Signal der Frequenz F₃ zur Erzeugung eines fünften Multitonalitätssignals, dessen Spektrum vier Hauptlinien bei den Frequenzen F_{B}-F₂-F₃, F_{B}-F₂+F₃, F_{B}+F₂-F₃ und F_{B}+F₂+F₃ umfasst;
- Erzeugen wenigstens eines periodischen Signals mit einer Frequenz gleich einer der Frequenzen F_{B}-F₂-F₃, F_{B}-F₂+F₃, F_{B}+F₂-F₃ und F_{B}+F₂+F₃ ausgehend von dem fünften Multitonalitätssignal.

15. Verfahren nach einem der Ansprüche 10 bis 14, ferner umfassend:
- beim Empfang eines Signals in einem der zwei Übertragungsfrequenzbänder (1006), eine erste Umsetzung des empfangenen Signals in ein Zwischenfrequenzband (1012) unter Verwendung eines der zwei periodischen Signale der Frequenzen F_{A}-F₁ und F_{A}+F₁, und dann eine zweite Umsetzung des aus der ersten Umsetzung hervorgegangenen Signals ins Basisband unter Verwendung eines der periodischen Signale der Frequenzen F_{B}-F₂, F_{B}+F₂, F_{B}-F₂-F₃, F_{B}-F₂+F₃, F_{B}+F₂-F₃ und F_{B}+F₂+F₃, und
- beim Senden eines Signals in dem anderen der zwei Übertragungsfrequenzbänder (1004), eine erste Umsetzung eines Signals im Basisband in das Zwischenfrequenzband (1012) unter Verwendung eines der periodischen Signale der Frequenzen F_{B}-F₂, F_{B}+F₂, F_{B}-F₂-F₃, F_{B}-F₂+F₃, F_{B}+F₂-F₃ und F_{B}+F₂+F₃, und dann eine zweite Umsetzung des aus der ersten Umsetzung hervorgegangenen Signals in das andere der zwei Übertragungsfrequenzbänder (1004) unter Verwendung des anderen der zwei periodischen Signale der Frequenzen F_{A}-F₁ und F_{A}+F₁.

## Claims

1. Device (1000) for emitting and/or receiving signals intended to be transmitted in at least two symmetrical transmission frequency bands (1004, 1006) in relation to a first frequency of symmetry F_{CA} and such that each one of the two transmission frequency bands (1004, 1006) comprises at least two channels (10, 12), or groups of channels (20, 22, 24, 26), symmetrical in relation to second frequencies of symmetry F_{CLA}, F_{CUA}, comprising at least:
- first means (102, 116) able to generate a periodic signal of frequency F_{A}, a periodic signal of frequency F_{B} = F_{A}/N1, a periodic signal of frequency F₁ equal to |F_{CA} - F_{CLA}| and a periodic signal of frequency F₂ equal to the difference between a central frequency of one of the channels or groups of channels and the second frequency of symmetry associated with said one of the channels or groups of channels, and wherein F_{A} = N1.(F_{CLA} + F₁)/(N1 + 1) with N1 a number greater than 1;
- second means (130-152, 156-164) able to carry out a first non-linear operation between the periodic signals of frequencies F_{A} and F₁ generating a first multitone signal of which the frequency spectrum comprises two main lines at frequencies F_{A}-F₁ and F_{A}+F₁, and able to carry out a second non-linear operation between the periodic signals of frequencies F_{B} and F₂ generating a second multitone signal of which the frequency spectrum comprises two main lines at frequencies F_{B}-F₂ and F_{B}+F₂.

2. Device (1000) according to claim 1, wherein the second means comprise at least one first mixer (130) able to carry out the first non-linear operation and a second mixer (136) able to carry out the second non-linear operation.

3. Device (1000) according to one of previous claims, wherein the first means comprise a first phase locked loop (102) able to output the periodic signals of frequencies F_{A} and F_{B} and a second phase locked loop (116) able to output the periodic signals of frequencies F₁ and F₂, or, when the frequency F_{A} corresponds to an integer multiple of each one of the frequencies F_{B}, F₁ and F₂, the first circuitry comprises a single phase locked loop able to output the periodic signals of frequencies F_{A}, F_{B}, F₁ and F₂.

4. Device (1000) according to one of previous claims, further comprising at least:
- first and second frequency recovery circuits (132, 134) receiving as input the first multitone signal and each one outputting a periodic signal respectively of frequency F_{A}-F₁ and F_{A}+F₁;
- third and fourth frequency recovery circuits (138, 140) receiving as input the second multitone signal and each one outputting a periodic signal respectively of frequency F_{B}-F₂ and F_{B}+F₂.

5. Device (1000) according to claim 4, further comprising, when each one of the two transmission frequency bands (1004, 1006) comprises at least two groups of at least two channels, third means (142, 148) able to perform a third non-linear operation between the periodic signal of frequency F_{B}-F₂ and a periodic signal of frequency F₃ generating a third multitone signal of which the frequency spectrum comprises two main lines at frequencies F_{B}-F₂-F₃ and F_{B}-F₂+F₃, and able to perform a fourth non-linear operation between the periodic signals of frequencies F_{B}+F₂ and F₃ generating a fourth multitone signal of which the frequency spectrum comprises two main lines at frequencies F_{B}+F₂-F₃ and F_{B}+F₂+F₃.

6. Device (1000) according to claim 5, further comprising at least:
- fifth and sixth frequency recovery circuits (144, 146) receiving as input the third multitone signal and each one outputting a periodic signal respectively of frequency F_{B}-F₂-F₃ and F_{B}-F₂+F₃;
- seventh and eighth frequency recovery circuits (150, 152) receiving as input the fourth multitone signal and each one outputting a periodic signal of frequency F_{B}+F₂-F₃ and F_{B}+F₂+F₃.

7. Device (1000) according to one of claims 4 to 6, wherein each frequency recovery circuit (132, 134, 138, 140, 144, 146, 150, 152) comprises at least one injection locked oscillator and/or a bandpass filter.

8. Device (1000) according to one of claims 1 to 3, further comprising:
- first and second frequency recovery circuits (132, 134) receiving as input the first multitone signal and each one outputting a periodic signal respectively of frequency F_{A}-F₁ and F_{A}+F₁;
- fourth means (156) able to perform a third non-linear operation between the second multitone signal and a periodic signal of frequency F₃ generating a fifth multitone signal of which the spectrum comprises four main lines at the frequencies F_{B}-F₂-F₃, F_{B}-F₂+F₃, F_{B}+F₂-F₃ and F_{B}+F₂+F₃;
- at least one switchable injection locked oscillator (158, 160, 162, 164) receiving as input the fifth multitone signal and outputting at least one periodic signal of frequency equal to one of the frequencies F_{B}-F₂-F₃, F_{B}-F₂+F₃, F_{B}+F₂-F₃ and F_{B}+F₂+F₃.

9. Device (1000) according to one of previous claims, further comprising:
- a conversion stage between the transmission frequency bands (1004, 1006) and an intermediate frequency band (1012), comprising at least one third mixer (1014) able to receive as input a signal received by the device (1000) in one of the two transmission frequency bands (1006) and one of the two periodic signals of frequencies F_{A}-F₁ and F_{A}+F₁ and at least one fourth mixer (1028) able to receive as input an intermediate frequency band signal (1012) intended to be emitted by the device (1000) in the other of the two transmission frequency bands (1004) and the other of the two periodic signals of frequencies F_{A}-F₁ and F_{A}+F₁;
- a conversion stage between the intermediate frequency band (1012) and a baseband, comprising a plurality of fifth mixers (1016.1 - 1016.m) each able to receive as input an output signal of the third mixer (1014) and one of the periodic signals of frequencies F_{B}-F₂, F_{B}+F₂, F_{B}-F₂-F₃, F_{B}-F₂+F₃, F_{B}+F₂-F₃ and F_{B}+F₂+F₃, and a plurality of sixth mixers (1026.1-1026.m) each able to receive as input a signal in baseband intended to be emitted by the device (1000) in said other of the two transmission frequency bands (1004) and one of the periodic signals of frequencies F_{B}-F₂, F_{B}+F₂, F_{B}-F₂-F₃, F_{B}-F₂+F₃, F_{B}+F₂-F₃ and F_{B}+F₂+F₃.

10. Method for emitting and/or receiving signals in at least two symmetrical transmission frequency bands (1004, 1006) in relation to a first frequency of symmetry F_{CA} and such that each one of the two transmission frequency bands (1004,1006) comprises at least two channels (10, 12), or groups of channels (20, 22, 24, 26), symmetrical in relation to second frequencies of symmetry F_{CLA}, F_{CUA}, comprising at least the steps of:
- generating a periodic signal of frequency F_{A}, a periodic signal of frequency F_{B} = F_{A}/N1, a periodic signal of frequency F₁ equal to |F_{CA} - F_{CLA}| and a periodic signal of frequency F₂ equal to the difference between a central frequency of one of the channels or group of channels and the second frequency of symmetry associated with said one of the channels or group of channels, and wherein F_{A} = N1.(F_{CLA} + F₁)/(N1 + 1) with N1 a number greater than 1;
- performing of a first non-linear operation between the periodic signals of frequencies F_{A} and F₁ generating a first multitone signal of which the frequency spectrum comprises two main lines at frequencies F_{A}-F₁ and F_{A}+F₁, and a second non-linear operation between the periodic signals of frequency F_{B} and F₂ generating a second multitone signal of which the frequency spectrum comprises two main lines at frequencies F_{B}-F₂ and F_{B}+F₂.

11. Method according to claim 10, further comprising the steps of:
- generating periodic signals of frequencies F_{A}-F₁ and F_{A}+F₁ using the first multitone signal;
- generating periodic signals of frequencies F_{B}-F₂ and F_{B}+F₂ using the second multitone signal.

12. Method according to claim 11, further comprising, when each one of the two transmission frequency bands (1004, 1006) comprises at least two groups of at least two channels, the performing of a third non-linear operation between the periodic signal of frequency F_{B}-F₂ and a periodic signal of frequency F₃ generating a third multitone signal of which the frequency spectrum comprises two main lines at frequencies F_{B}-F₂-F₃ and F_{B}-F₂+F₃, and a fourth non-linear operation between the periodic signals of frequencies F_{B}+F₂ and F₃ generating a fourth multitone signal of which the spectrum comprises two main lines at frequencies F_{B}+F₂-F₃ and F_{B}+F₂+F₃.

13. Method according to claim 12, further comprising the steps of:
- generating periodic signals of frequencies F_{B}-F₂-F₃ and F_{B}-F₂+F₃ using the third multitone signal;
- generating periodic signals of frequencies F_{B}+F₂-F₃ and F_{B}+F₂+F₃ using the fourth multitone signal.

14. Method according to claim 10, further comprising the steps of:
- generating periodic signals of frequencies F_{A}-F₁ and F_{A}+F₁ using the first multitone signal;
- performing of a third non-linear operation between the second multitone signal and a periodic signal of frequency F₃ generating a fifth multitone signal of which the spectrum comprises four main lines at the frequencies F_{B}-F₂-F₃, F_{B}-F₂+F₃, F_{B}+F₂-F₃ and F_{B}+F₂+F₃;
- generating of at least one periodic signal of frequency equal to one of the frequencies F_{B}-F₂-F₃, F_{B}-F₂+F₃, F_{B}+F₂-F₃ and F_{B}+F₂+F₃ using the fifth multitone signal.

15. Method according to one of claims 10 to 14, further comprising:
- during the receiving of a signal in one of the two transmission frequency bands (1006), a first transposition in an intermediate frequency band (1012) of the signal received using one of the two periodic signals of frequencies F_{A}-F₁ and F_{A}+F₁, then a second transposition in baseband of the signal coming from the first transposition using one of the periodic signals of frequencies F_{B}-F₂, F_{B}+F₂, F_{B}-F₂-F₃, F_{B}-F₂+F₃, F_{B}+F₂-F₃ and F_{B}+F₂+F₃, and
- during the emitting of a signal in the other of the two transmission frequency bands (1004), a first transposition in the intermediate frequency band (1012) of a signal in baseband using one of the periodic signals of frequencies F_{B}-F₂, F_{B}+F₂, F_{B}-F₂-F₃, F_{B}-F₂+F₃, F_{B}+F₂-F₃ and F_{B}+F₂+F₃, then a second transposition in the other of the two transmission frequency bands (1004) of the signal coming from the first transposition using the other of the two periodic signals of frequencies F_{A}-F₁ and F_{A}+F₁.
